(19) Europäisches Patentamt / European Patent Office / Office européen des brevets

(11) **EP 3 033 773 B1**

(12) **EUROPEAN PATENT SPECIFICATION**

(45) Date of publication and mention
of the grant of the patent:
**04.05.2022 Bulletin 2022/18**

(21) Application number: **14752845.9**

(22) Date of filing: **14.08.2014**

(51) International Patent Classification (IPC):
$H01L\ 31/0352$ (2006.01)    $H01L\ 31/0735$ (2012.01)
$H01L\ 31/0693$ (2012.01)    $H01L\ 31/0304$ (2006.01)
$H01L\ 31/0216$ (2014.01)    $H01L\ 31/0224$ (2006.01)

(52) Cooperative Patent Classification (CPC):
**H01L 31/035227; H01L 31/02167;
H01L 31/022466; H01L 31/0304; H01L 31/03529;
H01L 31/0693; H01L 31/0735; Y02E 10/544**

(86) International application number:
**PCT/EP2014/067457**

(87) International publication number:
**WO 2015/022414 (19.02.2015 Gazette 2015/07)**

(54) **RADIAL P-N JUNCTION NANOWIRE SOLAR CELLS**

NANODRAHTSOLARZELLEN MIT RADIALEN P-N-ÜBERGÄNGEN

CELLULES PHOTOVOLTAÏQUES À NANOFILS À JONCTION P-N RADIALES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **14.08.2013 GB 201314566
03.01.2014 GB 201400087
16.04.2014 GB 201406860**

(43) Date of publication of application:
**22.06.2016 Bulletin 2016/25**

(73) Proprietor: **Norwegian University of Science and
Technology (NTNU)
7491 Trondheim (NO)**

(72) Inventors:
• **LIM, Cheng Guan
610120 (SG)**
• **WEMAN, Helge
CH-1024 Ecublens (CH)**

(74) Representative: **Gill Jennings & Every LLP
The Broadgate Tower
20 Primrose Street
London EC2A 2ES (GB)**

(56) References cited:
**WO-A1-2013/092665    WO-A2-2013/190128**

FR-A1- 2 932 013    US-A1- 2010 193 768
US-A1- 2011 126 891    US-A1- 2012 032 148

• LIM CHENG G ET AL: "Numerical analysis and device optimization of radial p-n junction GaAs/AlxGa1-xAs core-shell nanowire solar c", 2013 13TH INTERNATIONAL CONFERENCE ON NUMERICAL SIMULATION OF OPTOELECTRONIC DEVICES (NUSOD), IEEE, 19 August 2013 (2013-08-19), pages 11-12, XP032506861, ISSN: 2158-3234, DOI: 10.1109/NUSOD.2013.6633099 ISBN: 978-1-4673-6309-9 [retrieved on 2013-10-15]
• ERIK C. GARNETT ET AL: "Nanowire Solar Cells", ANNUAL REVIEW OF MATERIALS RESEARCH, vol. 41, no. 1, 4 August 2011 (2011-08-04) , pages 269-295, XP055145860, ISSN: 1531-7331, DOI: 10.1146/annurev-matsci-062910-100434
• WIRTHS S ET AL: "Preparation of Ohmic contacts to GaAs/AlGaAs-core/shell-nanowires", APPLIED PHYSICS LETTERS, A I P PUBLISHING LLC, US, vol. 100, no. 4, 23 January 2012 (2012-01-23), pages 42103-42103, XP012156944, ISSN: 0003-6951, DOI: 10.1063/1.3678639 [retrieved on 2012-01-24]

**Description**

**FIELD OF THE TECHNOLOGY**

The present disclosure relates to photovoltaic devices, in particular nanowire solar cells with radial p-n junctions for high solar cell efficiencies.

**BACKGROUND**

Photovoltaic devices typically employ a planar thin-film structure, wherein a negatively doped (n-type) material is stacked on top of a positively doped (p-type) material or a positively doped (p-type) material is stacked on top of a negatively doped (n-type) material. In these planar photovoltaic devices, the light absorbing layer needs to be thick enough to effectively absorb impinging photons with energies larger than the bandgap energy of the light absorbing material. However, when the light absorbing layer in a planar structure is made thicker this compromises the effective collection of the photo-generated carriers as the thickness of the light absorbing layer may be larger than the diffusion length of the minority carriers. Therefore the design of typical planar photovoltaic devices leads to a compromise between the thickness of the light absorbing layer for efficient light absorption and the effectiveness of carrier collection, thereby imposing limits on the efficiencies of these devices.

For example, typical thin-film GaAs solar cells require a light absorbing layer several microns thick to effectively absorb photons with energies higher than its bandgap energy, but as the diffusion length of the minority carriers is typically only a few hundreds nanometres, many of the photo-generated carriers cannot be collected.

Rather than using planar p-n junctions in photovoltaic devices, radial p-n junctions are being investigated. In these structures, a long central p-type core extends out of a substrate and an n-type shell is wrapped around the core. In alternative configurations, the core is of an n-type material, while the shell is formed of a p-type material. Using this structure, one of the two photo-generated carrier types is collected in the shell orthogonally to the light absorption along the length of the core. Unlike in planar p-n junctions, increasing the length of the core to improve light absorption does not increase the distance the carriers need to travel before being collected, and therefore does not lead to the trade-off in light absorption and carrier collection found in typical planar devices.

Recent developments in the fabrication of nanowires extending out of substrates have made it possible to manufacture radial p-n junction photovoltaic devices. However, the efficiencies that have been achieved with these radial p-n junctions have been substantially less than corresponding planar devices, achieving solar cell efficiencies of less than 10% under one-sun AM1.5G solar spectrum illumination.

It is desirable for single-junction photovoltaic devices to achieve solar cell efficiencies as close to the Shockley-Queisser limit of -33.5% as possible, or even exceeding the limit, as higher solar cell efficiencies result in more solar energy collected per square metre of solar panel, leading to smaller footprints and potentially cheaper installations.

Also in the background art there are documents US 2010/193768 A1, which is directed towards silicon nanowires with p-type and n-type dopants, US 2011/126891 A1, which is directed towards nanorods with p-i-n junctions, US 2012/032148 A1, which is towards nanowires with p-n junctions, and FR 2 932 013 A1, which is towards nanowires and their processes of formation.

SUMMARY

The present invention, as set out in independent claim 1, provides a photovoltaic device comprising at least one nanowire structure fixed to a substrate, wherein each of the at least one nanowire structures comprises: a heavily doped p-type core having a proximal end fixed to the substrate and a distal end extending away from the substrate; and a lightly doped n-type shell around the p-type core so as to form a radial p-n junction; wherein the p-type core is formed of GaAs and the n-type shell is formed of $Al_xGa_{1-x}As$, wherein x has a value of less than or equal to 0.2; and wherein the doping density of the n-type shell is less than $10^{17}$ cm$^{-3}$.

Nanowires with p-type cores and n-type shells allow for improved carrier collection compared to planar photovoltaic devices, resulting in potentially improved solar cell efficiencies. While in planar photovoltaic devices the solar cell efficiencies are lowered with an increase in p-type doping, it has been found that by heavily doping the p-type layer nanowire core leads to substantial improvements in solar cell efficiency.

The p-type core and the n-type shell are III-V compounds.

The p-type core is formed of GaAs and the n-type shell is formed of $Al_xGa_{1-x}As$. GaAs compounds are particularly suited for photovoltaic devices, as the bandgap energy of around 1.4eV allows for high solar cell efficiencies in accordance with the Shockley-Queisser model.

x (the Al mole fraction) has a value less than or equal to 0.2. An Al mole fraction of 0.2 may minimise surface recombination and the energy barrier in the conduction band at the interface between the nanowire core and shell.

The p-type core is heavily doped. In some example embodiments the p-type core is sufficiently heavily doped to at least one of: maximise quasi-Fermi level energy splitting, maximise a built-in electric field of the nanowire structure, extend an absorption spectrum of the nanowire structure, and maximise one or more of diffraction and reflection of sunlight inwardly in the core. Maximising diffraction and/or reflection inwardly in the core may reduce optical reflection, enhance optical confinement as well as maximise photon recycling.

The doping density of the p-type core is greater than $10^{18}$ cm$^{-3}$ and preferably $10^{19}$ cm$^{-3}$.

The n-type shell is lightly doped. Lightly doping the n-type nanowire shell may minimise the carrier loss due to carrier-carrier scatterings, thereby maximising carrier collection efficiency and solar power conversion efficiency. Furthermore, lightly doping the n-type shell may maximise the depletion region in the shell to minimise carrier recombination in the shell, hence maximising carrier collection efficiency and solar power conversion efficiency.

The doping density of the n-type shell is less than $10^{17}$ cm$^{-3}$ and preferably around $10^{16}$ cm$^{-3}$.

In some example embodiments the n-type shell is sufficiently thin to minimise carrier recombination in the n-type shell. Furthermore, thin lightly-doped shell may enable the collection of high-energy or hot electrons, hence making it possible to achieve ultra-high solar power conversion efficiencies.

In some example embodiments the n-type shell has a thickness of between 20nm and 50nm, and preferably 40nm.

In some example embodiments the diameter of the p-type core is sufficiently large to maximise spectrum overlap between an incoming solar spectrum and optical propagation modes of the nanowire . The diameter of the p-type core may also be sufficiently large to achieve a good balance between carrier collection and the amount of spectrum overlap between an incoming solar spectrum and optical propagation modes of the nanowire.

In some example embodiments the diameter of the p-type core is greater than 300nm, and preferably 400nm.

In some example embodiments the length of the nanowire is sufficiently large to absorb deep-penetrating spectral components of an incoming solar spectrum. The length of the nanowire may be restricted to avoid the detrimental effects of severe hole pile-up.

In some example embodiments the length of the nanowire is between $5\mu$m and $7\mu$m, and preferably $6\mu$m.

In some example embodiments the substrate comprises silicon.

In some example embodiments the substrate comprises a graphitic layer (such as graphene or modified graphene). Graphitic layers are highly conductive, so may improve the solar power conversion efficiency and minimise carrier losses.

In some example embodiments the distal end of the nanowire comprises an anti-reflection coating.

In some example embodiments each of the at least one nanowire structures are coated in a transparent conductive oxide (TCO).

In some example embodiments, a planar TCO contact lies above the at least one nanowire structures.

In some example embodiments, an insulating polymer is disposed between the planar TCO contact and the at least one nanowire structures.

In some example embodiments the p-type core has a radius greater than 300nm (preferably 400nm) and is formed of GaAs with a doping density greater than $10^{18}$ cm$^{-3}$ (preferably $10^{19}$ cm$^{-3}$), the n-type shell has a thickness of less than 50nm (preferably 40nm) and is formed of $Al_{0.2}Ga_{0.8}As$ with a doping density less than $10^{17}$ cm$^{-3}$ (preferably $10^{16}$ cm$^{-3}$), and the nanowire structure has a length of between $5\mu$m and $7\mu$m, and preferably around $6\mu$m. This combination of material parameters and nanowire dimensions may lead to high solar cell efficiencies of above 20%, and preferably above 30%.

In another embodiment, the present disclosure provides a method of fabricating a photovoltaic device comprising at least one nanowire grown on a substrate, the method comprising: growing a nanowire comprising a heavily doped p-type core having a proximal end fixed to the substrate and a distal end extending away from the substrate, and an n-type shell around the p-type core.

In another embodiment, the present disclosure provides a solar cell comprising plurality of the photovoltaic devices descried in the embodiments above, wherein the plurality of photovoltaic devices are arranged in an array with a packing percentage of greater than 8%, preferably greater than 20%, and more preferably between 50 and 55%. By arranging an array of tightly packed photovoltaic devices in a solar cell, the light trapping is improved, thereby increasing the solar efficiency.

In another embodiment, the present disclosure provides a photovoltaic device comprising at least one nanowire structure fixed to a substrate, wherein each of the at least one nanowire structures comprise: a planar TCO contact above the at least one nanowire structures, wherein insulating polymer is disposed between the planar TCO contact and the at least one nanowire structures; a p-type core having a proximal end fixed to the substrate and a distal end extending away from the substrate; and an n-type shell around the p-type core.

## BRIEF DESCRIPTION OF DRAWINGS

Examples of the present proposed approach will now be described in detail with reference to the accompanying drawings, in which:

**Figure 1** is a cross section of a single core-shell nanowire solar cell on a substrate;

**Figures 2A and 2B** are schematic diagrams illustrating solar cells made out from an array of core-shell nanowires on a substrate;

**Figure 3** shows a three-layer slab illustrating a computational method used for determining optimum parameters of a nanowire;

**Figure 4** shows energy band diagrams in short-circuit condition for a range of p-type nanowire core doping densities;

**Figure 5** is a graph showing the short-circuit current density and open-circuit voltage as a function of the density of p-type nanowire core doping;

**Figure 6** shows electric-field profiles in short-circuit condition for a range of p-type nanowire core doping densities;

**Figures 7** shows energy band diagrams in short-circuit condition for a range of n-type nanowire shell doping densities;

**Figure 8** is a graph showing the short-circuit current density and open-circuit voltage as a function of the density of n-type nanowire shell doping;

**Figure 9** shows electric-field profiles in short-circuit condition for a range of n-type nanowire shell doping densities;

**Figure 10** is a chart showing solar cell efficiencies of a nanowire as a function of p-type nanowire core doping density and n-type nanowire shell doping density;

**Figure 11** shows energy band diagrams in short-circuit condition for a range of Al nanowire shell mole fractions;

**Figure 12** shows electric-field profiles in short-circuit condition for a range of Al nanowire shell mole fractions;

**Figure 13** is a graph showing the short-circuit current density and open-circuit voltage as a function of Al nanowire shell mole fraction;

**Figure 14** is a graph showing the solar cell efficiency as a function of Al nanowire shell mole fraction;

**Figure 15** is a graph showing solar cell efficiency as a function of p-type core nanowire diameter for a range of nanowire lengths;

**Figures 16** is a graph showing solar cell efficiency as a function of nanowire lengths;

**Figure 17** shows profiles of hole current densities along the length of a nanowire for a range of nanowire lengths; and

**Figure 18** is a graph showing solar cell efficiency as a function of shell thickness with different TCO contact types;

**Figure 19** is a graph showing the J-V characteristics (relationship between effective current density and voltage) of nanowires with different TCO contact types in optimal conditions;

**Figure 20** is a graph showing the J-V characteristics of nanowires with different TCO contact types in ideal theoretical conditions;

**Figure 21** shows energy band diagrams for different TCO contact types in optimal conditions;

**Figure 22** shows the carrier densities of profiles of nanowires with different TCO contact types in optimal conditions;

**Figure 23** shows the recombination rates of profiles of nanowires with different TCO contact types in optimal conditions;

**Figure 24** is a graph showing how solar cell efficiency of a nanowire array is affected by the nanowire packing percentage of the array;

**Figure 25** is a graph showing the J-V characteristics, solar cell efficiency, open-circuit voltage and fill factor of a nanowire array over a range of solar ray zenith angles of incidence; and

**Figure 26** is a graph showing the J-V characteristics, solar cell efficiency, open-circuit voltage and fill factor of a nanowire array over a range of solar ray azimuth angles of incidence.

## DETAILED DESCRIPTION

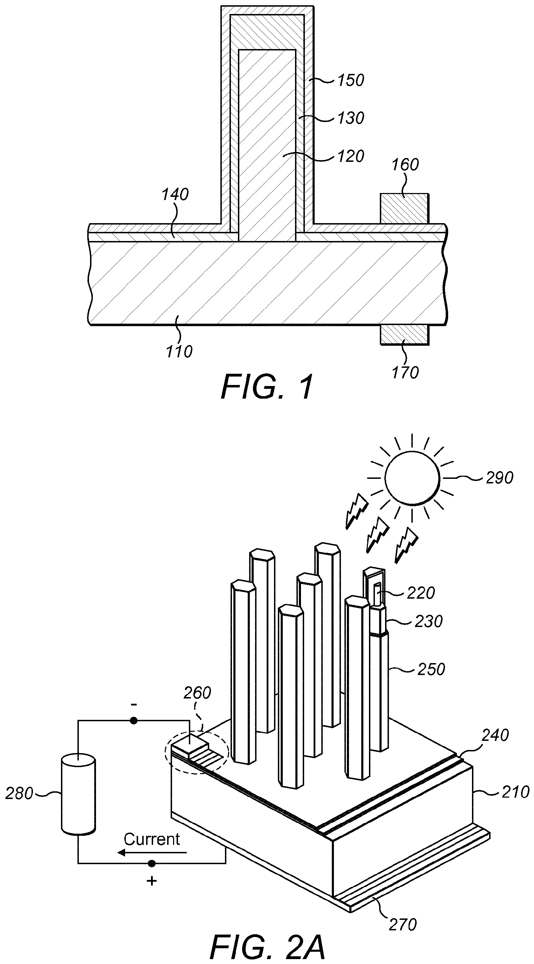

Reference will now be made to Figure 1 which shows a cross section of an example nanowire structure. A p-type core 120 may be grown on a substrate 110 through a catalyst-free or catalyst-assisted process, for example, or may be fabricated by some other means that ensure that a distal end is fixed to the substrate 110 while a distal end extends away from the substrate 110. The p-type core is the III-V compound GaAs (gallium arsenide), as its bandgap energy of around 1.4eV makes it suitable for achieving maximum solar cell efficiencies in the Shockley-Queisser model. The substrate 110 may be a p-type substrate to allow carriers to flow through from the p-type core.

The substrate 110 may by p-type silicon, for example, or any other semiconductor. The substrate 110 may include a high electrical conductive layer like a graphitic layer. The substrate may comprise a combination of layers, such as a silicon base with a thin graphitic layer on top, or even a graphitic layer on top of an insulating layer like glass. It would be clear to the skilled person what choice of substrate would be appropriate for allowing the core-shell nanowires to grow from the substrate and remain fixed, while still allowing for the transport of generated charge carriers.

An n-type shell 130 is formed around the p-type core 120. The n-type shell may be grown around the p-type core using a catalyst-free or catalyst-assisted process as well, or by some other means. The n-type shell is the III-V compound $Al_xGa_{1-x}As$, where 'x' is the Al molar fraction.

The n-type shell 130 may be electrically insulated from the substrate 110 by having an insulating layer 140 between the shell 130 and substrate 110. This insulating layer may be $SiO_2$, for example, and may be deposited on the substrate prior to growing the p-type core and n-type shell.

To form an electric contact to the n-type shell 130, the device may have either a conformal contact or planar top contact made of either a transparent conductive oxide (TCO) 150 or graphitic layer deposited on top.

To connect an electric load to the device, metal contacts may be deposited on the top 160 and bottom 170 of the device, such that the top metal contact 160 is in contact with the TCO layer 150 or graphitic layer, and therefore the n-type shell, and the bottom metal contact 170 is in contact with the p-type substrate 110, and therefore the p-type core 120.

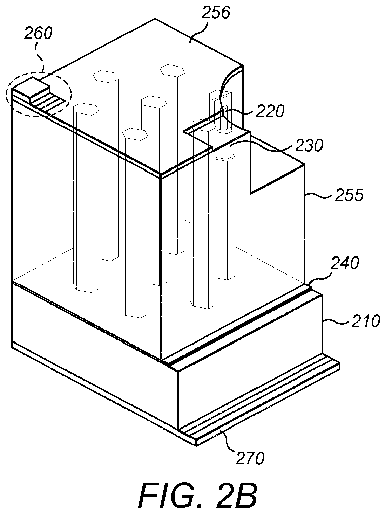

Figure 2A shows a schematic diagram of an array of nanowires arranged on a substrate 210. One nanowire is illustrated to show its interior, with a p-type core 220 at its centre extending away from the substrate 210, the p-type core 220 having an n-type shell 230 around it, and the whole nanowire coated in the TCO 250 layer. Figure 2 shows that between the substrate 210 and the n-type shell 230, there may be an insulating layer 240 such as $SiO_2$. A top metal contact 260 is connected to the negative terminal of an electrical load 280, while the bottom contact 270 is connected to the positive terminal of an electric load 280.

When light 290, typically with AM1.5G solar spectrum, is incident on the nanowire array, carriers are generated at each of the nanowires and current flows through the electric load 280.

Figure 2B shows a schematic diagram of an alternative embodiment to that illustrated in Figure 2A. Similar to Figure 2A, one nanowire is illustrated to show its interior, with a p-type core 220 at its centre extending away from the substrate 210, the p-type core 220 having an n-type shell 230 around it. Between the substrate 210 and the n-type shell 230, there may be an insulating layer 240 such as $SiO_2$, and a bottom contact 270 is disposed under the substrate 210. While Figure 2A illustrates a conformal TCO layer coating each individual nanowire structure, the embodiment illustrated in Figure 2B has a planar TCO contact 256 covering the array of nanowires, and the top metal contact 260 is in connection with the planar TCO contact 256. The planar TCO contact 256 may be supported by a transparent layer, preferably an insulating polymer 255 that substantially surrounds each of the nanowire structures and fills the gaps between the nanowire structures to effectively concentrate and confine sunlight in the nanowires for maximal sunlight absorption and photon recycling, hence maximising solar power conversion efficiency.

In some example embodiments, the nanowire is substantially cylindrical with a cylindrical core and a cylindrical shell around it. The nanowire may be substantially prism-shaped with an n-sided polygonal base, such as a hexagon, at the proximal end of the prism and in contact with the substrate and the other face at the distal end extending out away from the substrate. In other example embodiments, the nanowire is substantially conical, with the base at the proximal end near the substrate and the vertex at the distal end away from the substrate. In some example embodiments there is a heavily n-doped cap in between the n-type shell and the TCO or graphitic layer.

The physics involved in radial p-n junctions is different to that of established planar p-n junction photovoltaic devices. Therefore, when designing an efficient radial p-n junction, well-known assumptions, design considerations and prejudices associated with planar p-n junctions need to be challenged in order to achieve maximum solar cell efficiency. Therefore, when studying the device physics of a novel radial p-n junction, new computational methods and considerations need to be made.

In p-n junction devices, minority carrier transport may be an important consideration as it can control the majority carrier transport. Therefore, when designing a radial p-n junction, attention should be paid to the transport of minority carriers in order to obtain desirable voltage-current characteristics.

Unlike planar p-n junction solar cells, the boundaries of radial p-n junction nanowire solar cells are essentially three dimensional. Therefore, although more computational expensive, in the model used in the proposed solution the radial p-n junction nanowire solar cell is modelled in three dimensions where boundary conditions such as the radial boundary conditions are defined. Traditional approaches have typically used two-dimensional simulations to reduce the computational complexity of the simulation, but it has been determined that the errors involved in such a simplification is large enough to warrant a three-dimensional analysis.

As computational requirements are a key concern when simulating the behaviour of p-n junctions, and as utilising a three-dimensional model increases the computational costs significantly, computational efficiencies need to be found elsewhere to keep the required computational resources within manageable bounds. Therefore, in the proposed solution, the finite-element method and transfer-matrix methods are used to simulate the electric and optical properties of radial p-n junctions. More specifically, the complex wave impedance approach is used to simulate the optical transports in the device, and Poisson's equation and carrier continuity equations are solved to determine the electrical transports.

In the computations performed, a GaAs/$Al_xGa_{1-x}$As core-shell nanowire structure is used. However, it should be clear to the person skilled in the art how to adapt the computations for any p-type/n-type core-shell structure, such as III-V compounds, and how the results of these simulations can be adapted to other material choices.

It was found that by assuming a core diameter of 100nm, a shell thickness of 100nm, and a nanowire length of 3μm leads to high computational efficiencies, so where these parameters are not initially being varied, they are used for the simulations, particularly as they are in-line with what is practically feasible to construct.

To improve the computational efficiencies of the simulation, it may be advantageous to simulate only a single nanowire structure, rather than an array. This would be an appropriate simplification to make, as the only effect not taken into account by considering individual nanowires instead of array would be light trapping / concentrating / confining effects, which would not decrease the solar cell efficiencies calculated anyway. On the contrary, light trapping / concentrating / confining effects may further improve the solar cell efficiency calculated.

To ensure an adequate compromise between computational requirements and realistic results, the complex wave-impedance approach is used to simulate the propagation of sunlight through the single radial p-n junction GaAs/$Al_xGa_{1-x}$As core-shell nanowire solar cell. This approach may be used to compute the propagation of electromagnetic-waves efficiently using the transfer-matrix method and the finite-element method. The approach involves discretizing the propagation media into fine fragments, constructing the transfer-matrix for each fragment, and solving the transfer-matrices using the finite-element method.

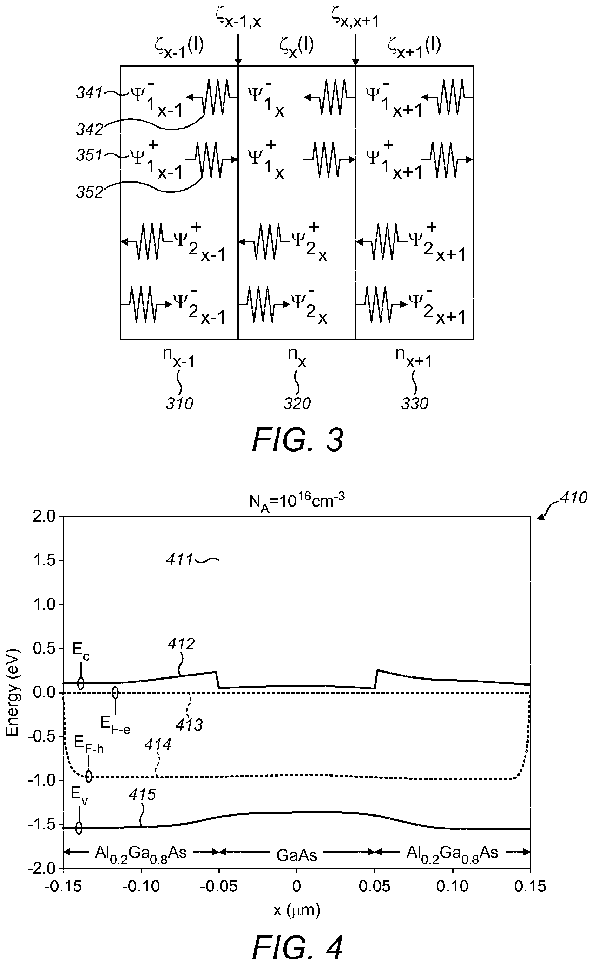

Figure 3 illustrates a complex wave-impedance approach using a three layer slab (310, 320 and 330), as an example. In this example two lightwaves, $\Psi_1$ and $\Psi_2$, propagating through the three-layer slab (310, 320 and 330) in opposite directions are considered. The lightwave $\Psi_1$ has a forward travelling component $\Psi_1^+$ 351 indicated by the superscript '+' sign and arrow 352. The lightwave $\Psi_1$ also has a backward travelling component $\Psi_1^-$ 341 indicated by the superscript '-' sign and arrow 342. As each lightwave passes through a different slab $n_{x-1}$ 310, $n_x$ 320, and $n_{x+1}$ 330, the slab it is passing is indicated by the subscript sign. For example, component $\Psi_{2x+1}^+$ is the forward travelling component of $\Psi_2$ in the right-most slab $n_{x+1}$ 330.

The forward travelling lightwaves in the centre layer $n_x$ 320 , $\Psi_{1x}^+$ and $\Psi_{2x}^+$ , are represented as follows:

$$\begin{bmatrix} \Psi_{2x}^+ \\ \Psi_{1x}^+ \end{bmatrix} = \xi_{x,x+1} \cdot \begin{bmatrix} \Psi_{1x+1}^- \\ \Psi_{2x+1}^- \end{bmatrix}$$

Where $\xi_{x,x+1}$ is the transfer-matrix for the interface between the centre layer $n_x$ 320 and the layer on the right

$n_{x+1}$ 330.

The backward travelling or reflected lightwaves in the centre layer $n_x$ 320, $\Psi_{1_x}^-$ and $\Psi_{2_x}^-$, are represented as follows:

$$\begin{bmatrix} \Psi_{1_x}^- \\ \Psi_{2_x}^- \end{bmatrix} = \xi_x(l) \cdot \begin{bmatrix} \Psi_{2_x}^+ \\ \Psi_{1_x}^+ \end{bmatrix}$$

Where $\xi_x(l)$ is the propagation transfer-matrix for the centre layer $n_x$ 320. The propagation transfer-matrix $\xi_x(l)$ and interfacial transfer-matrix $\xi_{x,x+1}$ are expressed as follows:

$$\xi_x(l) = \begin{bmatrix} e^{2\pi i \cdot n_x \cdot \cos(\theta_x l/\lambda)} & 0 \\ 0 & e^{-2\pi i \cdot n_x \cdot \cos(\theta_x l/\lambda)} \end{bmatrix}$$

$$\xi_{x,x+1} = \frac{1}{2Z_x} \begin{bmatrix} Z_x + Z_{x+1} & Z_x - Z_{x+1} \\ Z_x - Z_{x+1} & Z_x + Z_{x+1} \end{bmatrix}$$

Where $n_x$ is the complex refractive index for layer x, $\theta_x$ is the angle of refraction for layer x, l is it propagation distance in the given layer, $\lambda$ is the wavelength of the incident light, and $Z_x(Z_{x+1})$ is the complex wave-impedance for layer x (x+1). For a transverse electric (TE) wave, the mathematical expression for $Z_x$ is $n_x \cos(\theta_x)$, and for tranverse-magetic (TM) waves, it is expressed as $n_x \div \cos(\theta_x)$. The spatial intensity $\tilde{I}_x(l)$ in layer $n_x$ 320, is given by the following:

$$\tilde{I}_x(l) = \frac{Re\{Z_x\}}{Re\{Z_0\}} \cdot \left| \xi_x(l) \cdot \begin{bmatrix} \Psi_{1_x}^- \\ \Psi_{2_x}^- \end{bmatrix} \right| \; [\text{W/m}^2]$$

Where $Z_0$ is the complex wave-impedance of free space.

To simulate the characteristics of the radial p-n junction GaAs/Al$_x$Ga$_{1-x}$As core-shell nanowire solar cells, the optical simulation is coupled with the electrical simulation to determine the electrical characteristics of the device. Carrier transport simulations may be performed by solving the Poisson equation and charged carrier continuity equations utilising specific models to account for certain phenomena.

In order to achieve realistic results from the simulation, particular attention may be paid to ensure that the physical parameters of the materials are as accurate as possible and the phenomena affecting the values of those physical parameters are accounted for as much as necessary.

For example, the magnitude of the change in optical absorption around the GaAs bandgap due to change in doping level has been traditionally observed as relatively small compared to the magnitude of the absorption peak, therefore traditional approaches may have ignored this effect. However, the effect on optical generation has actually been found to be significant in radial p-n junctions. It was discovered that traditional approaches had an underestimation of approximately 60% in solar energy conversion efficiency when the above phenomenon was neglected. Therefore, in the simulations used in the proposed solution, the complex refractive index of the materials and the parameters associated with carrier transports are represented with a high accuracy.

The optical absorption coefficient $\alpha$ of materials used is determined from the complex refractive index through the following relation:

$$\alpha = 4\pi \frac{\tilde{n}}{\lambda} \; [\text{cm}^{-1}]$$

Where $\tilde{n}$ is the imaginary part of the complex refractive index. With $\alpha$ known, the optical generation can be calculated with the following equation:

$$G = \alpha \eta_i \frac{I}{h\nu} \; [\text{cm}^{-3}\text{s}^{-1}]$$

Where $\eta_i$ is the internal quantum efficiency, h is the Planck's constant, and $\nu$ is the frequency of the incident light. Assuming that each photon will generate an electron-hole pair, the value of $\eta_i$ may be taken as 1.

Other parameters to calculate include the doping-dependent carrier mobility in GaAs ($\mu_{GaAs}$), $Al_xGa_{1-x}As$ ($\mu_{AlGaAs}$), and Si ($\mu_{Si}$), and these parameters may be determine using the following empirical models:

$$\mu_{GaAs,AlGaAs} = \mu_{min} + \frac{\mu_0}{1+(N_{A,D}/N_o)} \text{ [cm}^2\text{/Vs]}$$

$$\mu_{Si} = \mu_0 e^{-(P_c/N_{A,D})} + \frac{\mu_{max}}{1+(N_{A,D}/C_r)^{\gamma m}} - \frac{\mu_1}{1+(C_s/N_{A,D})^{\beta}} \text{ [cm}^2\text{/Vs]}$$

Where $N_{A,D}$ is the doping density, and $\mu_{min}$, $\mu_{max}$, $\mu_0$, $\mu_1$, $\gamma_m$, $\beta$, No, Pc, Cr and $C_s$, are material-specific model parameters. As the loss of photo-generated carriers through radiative recombination, Auger recombination, Shockley-Read-Hall recombination, and surface combination may have a major effect on the solar energy conversion efficiency of solar cells, some or all of these processing may be considered using the following mathematical models. The radiative recombination rate, $R_{radiative}$, is determined using the following equation:

$$R_{radiative} = C_{radiative} \cdot (np - n_i^2) \text{ [cm}^{-3}\text{s}^{-1}\text{]}$$

Where $C_{radiative}$ is the radiative coefficient, and n, p and $n_i$ are the electron density, hole density, and effective intrinsic electron density respectively. The Auger recombination rate, $R_{Auger}$, may be obtained by the following equation:

$$R_{Auger} = \left(n\, C_{n_{Auger}} + p\, C_{p_{Auger}}\right)(np - n_i^2) \text{ [cm}^{-3}\text{s}^{-1}\text{]}$$

Where $C_{n\_Auger}$ and $C_{p\_Auger}$ are the Auger recombination coefficients for electrons and holes, respectively. The Shockley-Read-Hall recombination rate, $R_{SRH}$ may be determined from:

$$R_{SRH} = \frac{np-n_i^2}{\tau_p(n+n_i)+\tau_n(p+n_i)} \text{ [cm}^{-3}\text{s}^{-1}\text{]}$$

where $\tau_p$ and $\tau_n$ are the hole and electron lifetimes, respectively. These hole and electron lifetimes may be determined using the following Scharfetter relation between doping density and carrier lifetime:

$$\tau_{p,n} = \frac{\tau_0}{1+(\frac{N_{A,D}}{N_{ref}})} \text{ [s]}$$

Where $N_{A,D}$ is the doping density and $N_{ref}$ is the reference doping density. The surface recombination rate $R_{surface}$ may be calculated using:

$$R_{surface} = \frac{np-n_i^2}{(n+n_i)/s_p+(p+n_i)/s_n} \text{ [cm}^{-2}\text{s}^{-1}\text{]}$$

Where $s_p$ and $s_n$ are the surface recombination velocities for holes and electrons, respectively. Finally, the trap-assisted Auger recombination rate, $R_{TAA}$ may be computed using the following equation:

$$R_{TAA} = \frac{np-n_i^2}{\{\tau_p/[1+\tau_p C_p^{TAA}(n+p)]\}(n+n_i)+\{\tau_n/[1+\tau_n C_n^{TAA}(n+p)]\}(p+n_i)} \text{ [cm}^{-3}\text{s}^{-1}\text{]}$$

Where $C_p^{TAA}$ and $C_n^{TAA}$ are the trap-assisted Auger recombination coefficients for holes and electrons respectively.

The parameters mentioned above are examples of parameters that may be of interest when performing simulations. However, there are several other parameters not mentioned that the skilled person would know to include that are readily available in semiconductor device literature and fundamental equations within the field.

Performing simulations based on the above approach, the dependence of band structure, electric field distribution, and carrier recombination in radial p-n junctions on parameters such as doping levels, material compositions and the structure of the nanowire may be determined to find combinations of parameters with improved solar cell efficiencies.

The effect of the doping density of the p-type core may be determined by assessing the changes in energy band diagrams over a range of p-type doping densities while the keeping the n-type shell doping density constant.

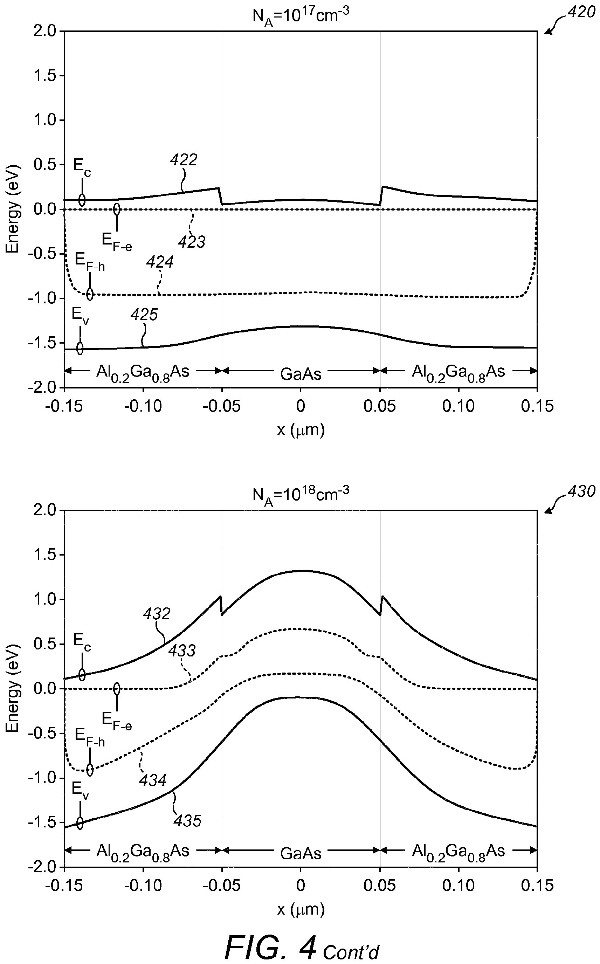

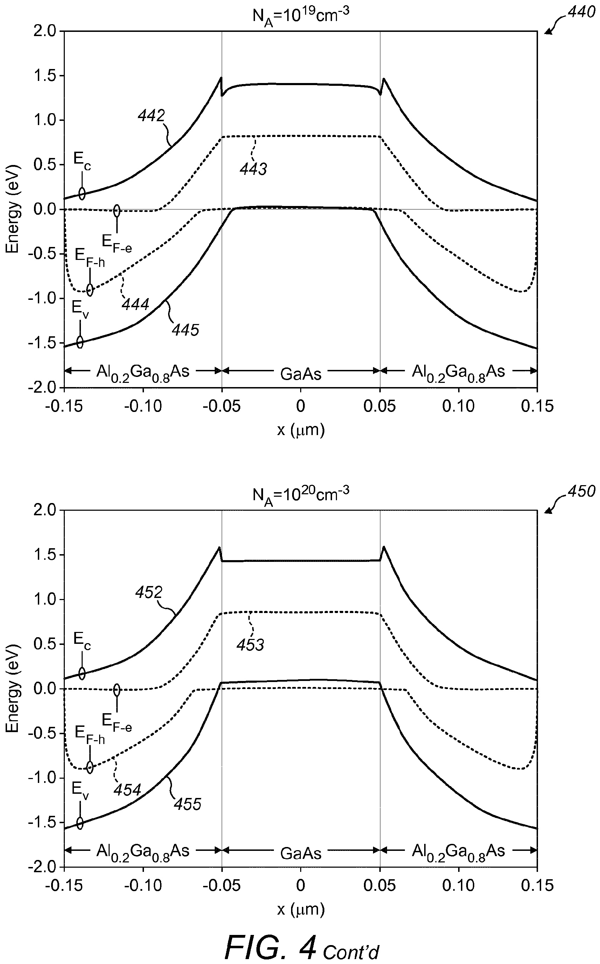

Figure 4 shows the results of simulating the energy band diagrams in short-circuit conditions for a range of p-type core doping densities. In the example simulations presented in Figure 4, the p-type core is GaAs, the n-type shell is $Al_{0.2}Ga_{0.8}As$, and the range of p-type doping densities is between $10^{16}cm^{-3}$ and $10^{20}cm^{-3}$.

The energy band diagram for p-type doping density of $10^{16}cm^{-3}$ is shown in 410. The x-axis shows the horizontal distance from the centre of the p-type core (indicated by $x=0\mu m$) and the y-axis shows the energy level (eV) of the bands. The vertical line at $-0.05\mu m$ 411 shows the boundary between the n-type shell and p-type core, as does the line at $+0.05\mu m$.

Solid line 412 shows the conduction band $E_c$ along the profile of the radial p-n junction. Similarly lines 422, 432, 442, and 452 shows the conduction bands for p-type core doping densities of $10^{17}cm^{-3}$, $10^{18}cm^{-3}$, $10^{19}cm^{-3}$, and $10^{20}cm^{-3}$, respectively. The other solid line 415 shows the valence band $E_v$ along the profile of the radial p-n junction, with lines 425, 435, 445, and 455 shows the valence bands for p-type core doping densities of $10^{17}cm^{-3}$, $10^{18}cm^{-3}$, $10^{19}cm^{-3}$, and $10^{20}cm^{-3}$, respectively.

Quasi-Fermi level energy splitting is indicated in graph 410, with dotted line 413 indicating the quasi-Fermi level energy for electrons ($E_{F-e}$) and dotted line 414 indicating the quasi-Fermi level energy for holes ($E_{F-h}$). The quasi-Fermi level energy for electrons is also shown as lines 423, 433, 443, and 453 for p-type core doping densities of $10^{17}cm^{-3}$, $10^{18}cm^{-3}$, $10^{19}cm^{-3}$, and $10^{20}cm^{-3}$, respectively, and the quasi-Fermi level energy for holes are shown as lines 424, 434, 444, and 454 for p-type core doping densities of $10^{17}cm^{-3}$, $10^{18}cm^{-3}$, $10^{19}cm^{-3}$, and $10^{20}cm^{-3}$, respectively.

The quasi-Fermi level energy splitting for $N_A=10^{16}cm^{-3}$ (410) and $N_A=10^{17}cm^{-3}$ (420) remains relatively constant as shown by the profile of 413 and 414, and 423 and 424. However, in band diagram 430, which shows an increased p-type core doping density of $N_A=10^{18}cm^{-3}$, there is a large step change in the quasi-Fermi level energy splitting as shown in 433 and 434, compared to the quasi-Fermi level energy splitting 423 and 424 in band diagram 420. This step-change remains as the p-type core doping density is increased to $10^{19}cm^{-3}$ (440) and $10^{20}cm^{-3}$ (450). It would therefore be reasonable to expect that for these material parameters, when the doping density of the p-type GaAs core is higher than $10^{17}cm^{-3}$ the open circuit voltage would increase considerably.

A heavily doped p-type GaAs core is also advantageous as it can diffract sunlight towards the normal axis (i.e., inwardly in the core) and may result in a 10% reduction in optical reflection loss compared to planar p-n junction GaAs solar cell with no anti-reflection coatings, and at the same time improves photon recycling.

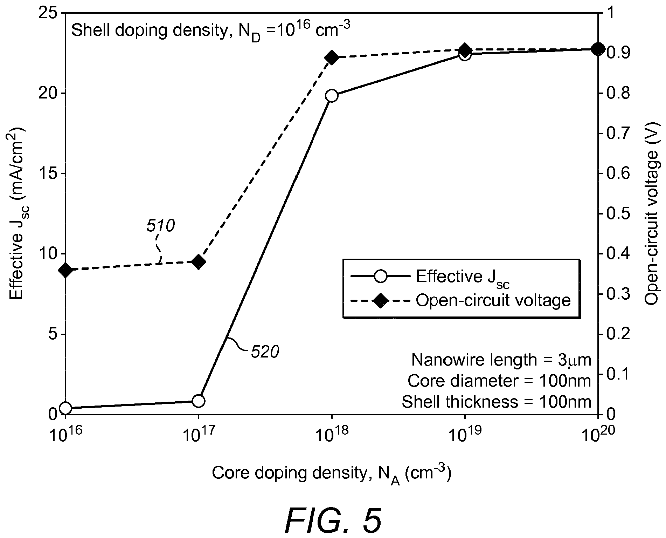

Figure 5 shows a graph of the short-circuit current density and open-circuit voltage as a function of the density of p-type core doping and does indicate a significant increase in open-circuit voltage 510 from 0.383V to 0.889V when increasing the p-type core doping density above $10^{17}cm^{-3}$. There is a similarly large increase of short-circuit current density 520 from the same increase in p-type core doping.

Given the teaching of common general knowledge regarding planar p-n junctions, this result is surprising, as the magnitude of change in optical absorption around the GaAs band gap due to change in doping levels is typically very small compared to the magnitude of the absorption peak. By performing calculations using a three-dimensional model and by taking extra care to maintain the accuracy of parameters associated with carrier transport and light propagation, for example, the result of increasing p-type core doping to improve open-circuit voltage and short-circuit current density were discovered.

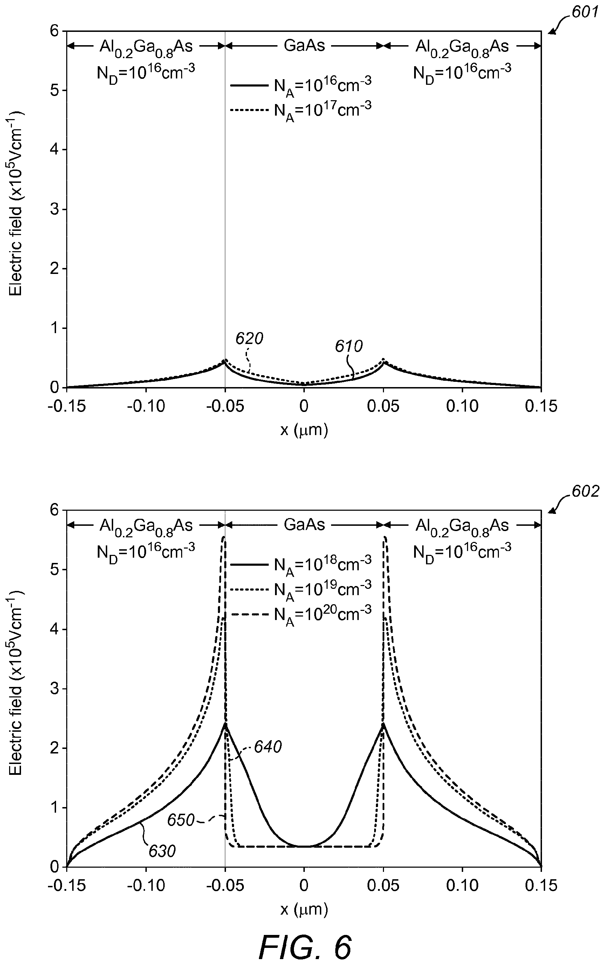

Figure 6 shows the electric field profiles in short-circuit conditions over a range of p-type core doping densities. Graph 601 shows the electric field profiles where the p-type core doping densities are $10^{16}cm^{-3}$ (610) and $10^{17}cm^{-3}$ (620). The increase in doping density from $10^{16}cm^{-3}$ (610) to $10^{17}cm^{-3}$ (620) resulted in a relatively small change in the electric field profile. Graph 602, on the other hand, shows electric field profiles for p-type doping levels of $10^{18}cm^{-3}$ (630) and higher. Comparing graphs 601 and 602 shows that the electric field increases significantly when the p-type doping increases above $10^{17}cm^{-3}$, as shown by the substantially stronger and well-distributed electric field profiles 630, 640 and 650 for p-type doping densities $10^{18}cm^{-3}$, $10^{19}cm^{-3}$, and $10^{20}cm^{-3}$, respectively. This result indicates that increasing the p-type doping density over $10^{17}cm^{-3}$ would lead to a significant increase in short-circuit current as a result of higher carrier collection efficiency.

For p-type core doping densities higher than $10^{18}cm^{-3}$, the short-circuit current density increases marginally due to band-gap shrinkage of the p-type core when heavily doped which causes the absorption spectrum to be extended.

From the above results it is clear that heavily doping the p-type core of the nanowire structure can lead to increased quasi-Fermi level energy splitting and a stronger, well-distributed electric field in a radial p-n junction. This was found to cause the open circuit voltage and short circuit current to increase substantially for heavily doped p-type cores, thereby leading to higher solar cell efficiencies.

The term heavily doped is a term well known in the art, and is typically used when the number of dopant atoms are of the order of one per ten thousand atoms or more. The doping density of a heavily doped material may vary depending on the material, while p-type GaAs may be considered heavily doped if at $10^{18}$cm$^{-3}$, for p-type silicon this may be higher at $10^{20}$cm$^{-3}$. For the material parameters chosen in this simulation, p-type core doping densities above $10^{17}$cm$^{-3}$ would lead to high solar cell efficiencies.

In another example, analysis is performed on the characteristics of a $3\mu$m length nanowire with a 400nm diameter GaAs core, a 50nm thick Al$_{0.2}$Ga$_{0.8}$As shell with an n-type doping density of $10^{16}$cm$^{-3}$. In this example, the p-type doping density is increased, and it is found that the short circuit current density increases steeply between core doping densities of $2\times10^{17}$cm$^{-3}$ and $4\times10^{17}$cm$^{-3}$ when the long-wavelength end of the GaAs absorption spectrum widens with increasing p-type doping. The short circuit current density eventually saturates at $3\times10^{-18}$cm$^{-3}$ when the absorption spectrum ceases to widen on further increases in p-type doping.

Increasing the p-type doping density also increases the internal electric field, thereby changing the width of the depletion region in the core and shell, causing the built-in electromotive force to vary accordingly. Therefore, for core doping densities above $10^{18}$cm$^{-3}$, the widening of the depletion region in the shell may stop when carrier diffusion ceases, whereas the depletion region in core core becomes narrower. Therefore, the built-in electromotive force at core doping densities above $10^{18}$cm$^{-3}$ may remain roughly constant even as the internal electric field increases, leading to a constant open-circuit voltage for core doping densities above $10^{18}$cm$^{-3}$.

In yet another example, rather than varying the core doping density in nanowires with conformal sidewall TCO contacts (such as in Figure 2A), simulations can be performed when varying the core doping densities in nanowires with planar TCO contacts (such as in Figure 2B). In the example simulation performed, the nanowire structure with a planar TCO contact has a 400nm diameter GaAs core, and a 50nm thick Al$_{0.2}$Ga$_{0.8}$As shell with an n-type doping density of $10^{16}$cm$^{-3}$. The nanowire with a planar TCO contact may have much higher short-circuit current densities and open-circuit voltages compared to an equivalent nanowire with a conformal contact. This is because the planar contact would not suffer from the same amount of band-bending as in a conformal contact, and therefore there will be a reduced build-up of uncollected carriers, resulting in a larger electromotive force. However, at p-type doping densities above roughly $7\times10^{16}$cm$^{-3}$ the planar contact embodiment may experience carrier avalanche effects, thereby causing uncollected carriers and leading to a junction breakdown at a core doping density of roughly $1.6\times10^{17}$cm$^{-3}$.

In the example simulations provided above, a nanowire with a planar TCO contact may reach a maximum solar cell efficiency of 10.5% at a core doping density of $7\times10^{16}$cm$^{-3}$, while a nanowire with a conformal contact may reach a maximum solar efficiency of 10.3% at a core doping density of $6\times10^{18}$cm$^{-3}$.

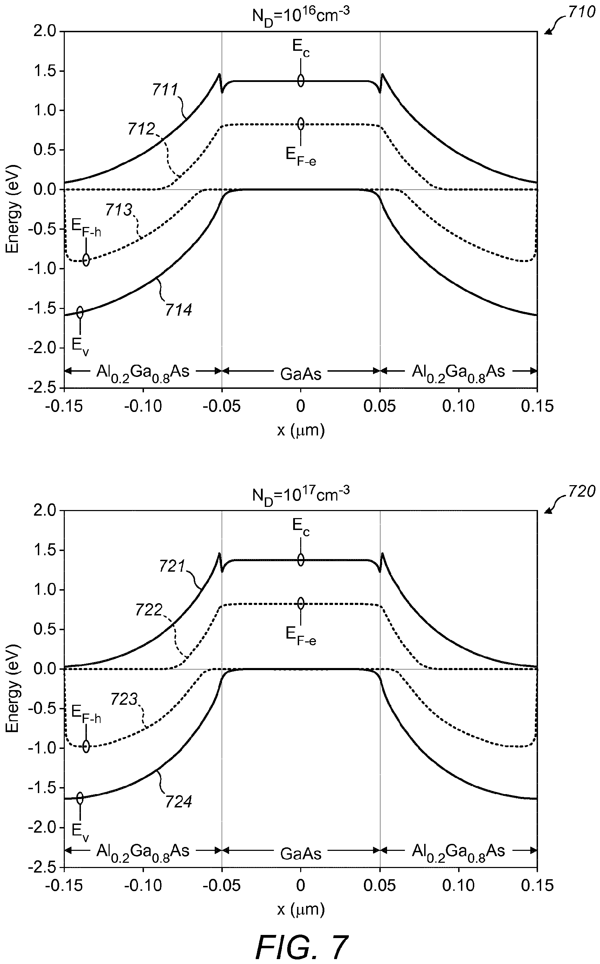

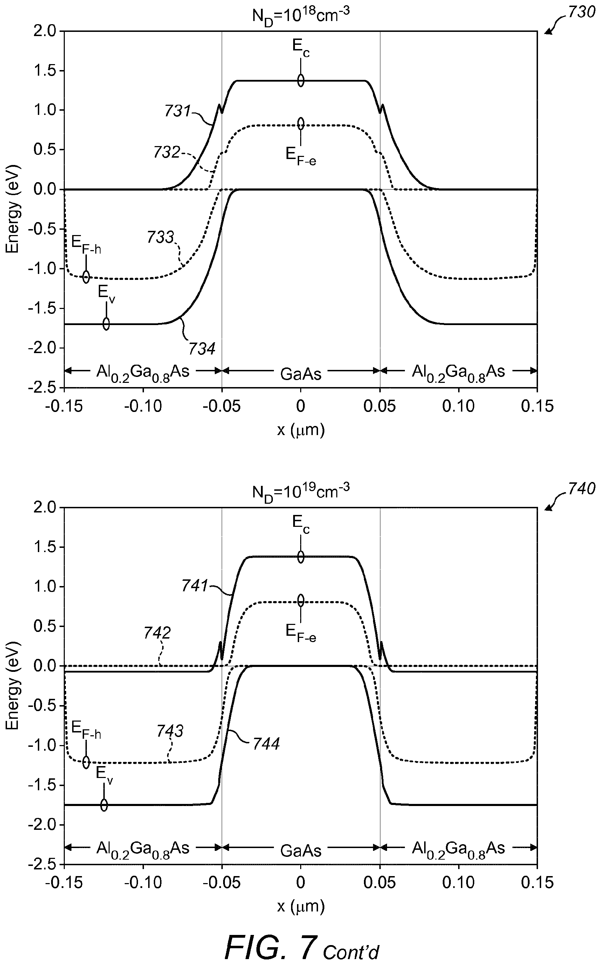

Figure 7 shows the results of simulating the energy band diagrams in short-circuit conditions for a range of n-type shell doping densities. In the example simulations presented in Figure 7, the n-type shell is Al$_{0.2}$Ga$_{0.8}$As, the p-type core is GaAs, the p-type doping density is fixed at $10^{19}$cm$^{-3}$ and the range of n-type shell doping densities ranges between $10^{16}$cm$^{-3}$ and $10^{19}$cm$^{-3}$.

The energy band diagram for n-type shell doping density of $10^{16}$cm$^{-3}$ is shown in 710. Solid line 711 shows the conduction band $E_c$ along the profile of the radial p-n junction. Similarly lines 721, 731, and 741, shows the conduction bands for n-type shell doping densities of $10^{17}$cm$^{-3}$, $10^{18}$cm$^{-3}$, and $10^{19}$cm$^{-3}$, respectively. The other solid line 714 shows the valence band $E_v$ along the profile of the radial p-n junction, with lines 724, 734, and 744 shows the valence bands for n-type shell doping densities of $10^{17}$cm$^{-3}$, $10^{18}$cm$^{-3}$, and $10^{19}$cm$^{-3}$, respectively.

Quasi-Fermi level energy splitting is indicated in graph 710, with dotted line 712 indicating the quasi-Fermi level energy for electrons ($E_{F-e}$) and dotted line 713 indicating the quasi-Fermi level energy for holes ($E_{F-h}$). The quasi-Fermi level energy for electrons is also shown as lines 722, 732, and 742 for n-type shell doping densities of $10^{17}$cm$^{-3}$, $10^{18}$cm$^{-3}$, and $10^{19}$cm$^{-3}$ respectively, and the quasi-Fermi level energy for holes are shown as lines 723, 733, and 743 for n-type shell doping densities of $10^{17}$cm$^{-3}$, $10^{18}$cm$^{-3}$, and $10^{19}$cm$^{-3}$ respectively.

As shown across the four charts 710, 720, 730 and 740, the quasi-Fermi-level energy splitting between the p-type core and n-type shell was relatively constant when increasing the n-type shell doping density from $10^{16}$cm$^{-3}$ to $10^{20}$cm$^{-3}$, indicating a potentially weak dependence of open-circuit voltage on n-type doping density in the shell.

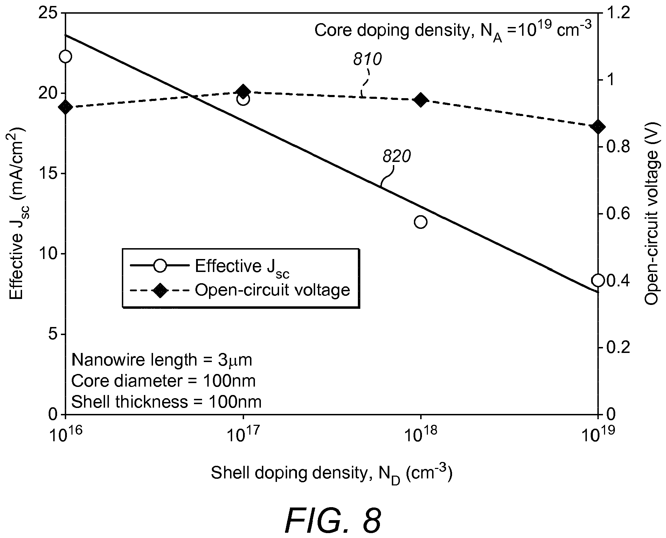

Figure 8 shows a graph of short-circuit current density 820 and open-circuit voltage 810 as a function of the density of n-type shell doping and does indicate a limited change in open-circuit voltage 810 as the n-type doping density was increased over the range. In fact, at n-type doping densities above of $10^{18}$cm$^{-3}$, it was noticeable that the open-circuit voltage 810 began to drop gradually as a result of reduced quasi-Fermi-level energy splitting between the p-type core and n-type shell and the fact that the increase in electric field does not keep up with the decrease in depletion width.

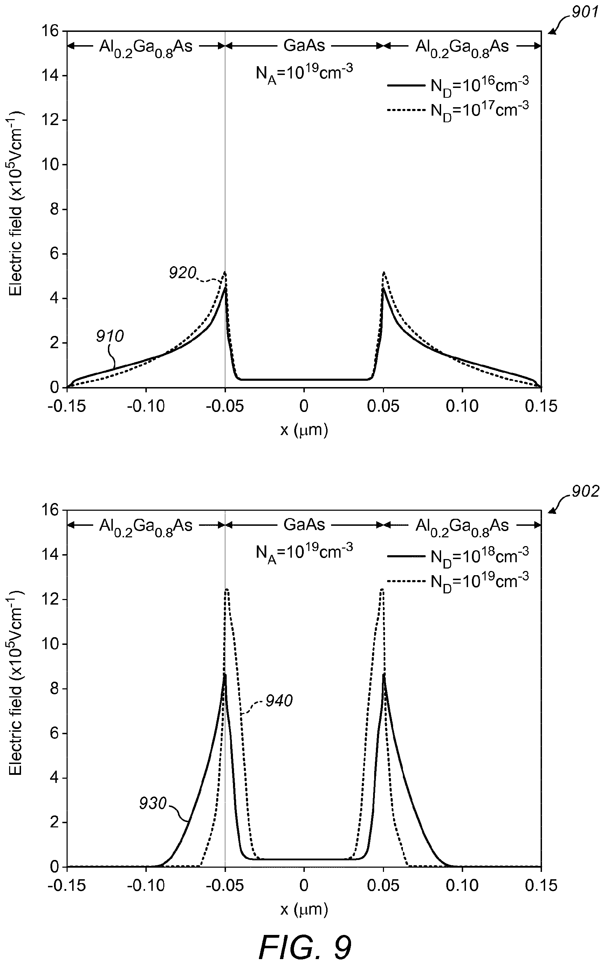

Figure 9 shows the electric field profiles in short-circuit conditions over a range of n-type doping densities. Graph 901 shows the electric field profiles where the n-type doping densities are $10^{16}$cm$^{-3}$ (910) and $10^{17}$cm$^{-3}$ (920). For these doping densities, the depletion width is shown to be relatively wide.

Graph 902, shows the electric profiles for higher n-type shell doping densities of $10^{18}$cm$^{-3}$ (930) and $10^{19}$cm$^{-3}$

(940). Compared to the electric field profiles in graph 901, the electric-field is larger but the depletion width significantly reduced. As a result, the open-circuit voltage only reduced marginally. Increasing the doping density from $10^{18}$cm$^{-3}$ 930 to $10^{19}$cm$^{-3}$ 940 reduced the depletion width, causing the open-circuit voltage to drop slightly because the increase in electric-field with increasing doping density does not keep up with the decrease in depletion width.

The electric-field plots shown in Figure 9 show that the depletion width in the p-type core increases with increasing n-type shell doping density whereas the depletion width in the n-type shell decreases. Such a decrease in n-type depletion width would therefore lead to a decrease in short-circuit current. As shown in line 820 of Figure 8, the short-circuit current density does decrease with increasing n-type shell doping density, as carrier recombination due to carrier-carrier scatterings in the shell increased as the depletion width in the n-type shell narrows.

From the example simulations shown in Figures 7, 8 and 9, it may be advantageous to ensure that the n-type shell should be lightly doped, for example at $10^{16}$cm$^{-3}$ for Al$_{0.2}$Ga$_{0.8}$As. The term lightly doped is a term well known in the art, and is typically used when the number of dopant atoms are of the order of one per 100 million atoms or fewer.

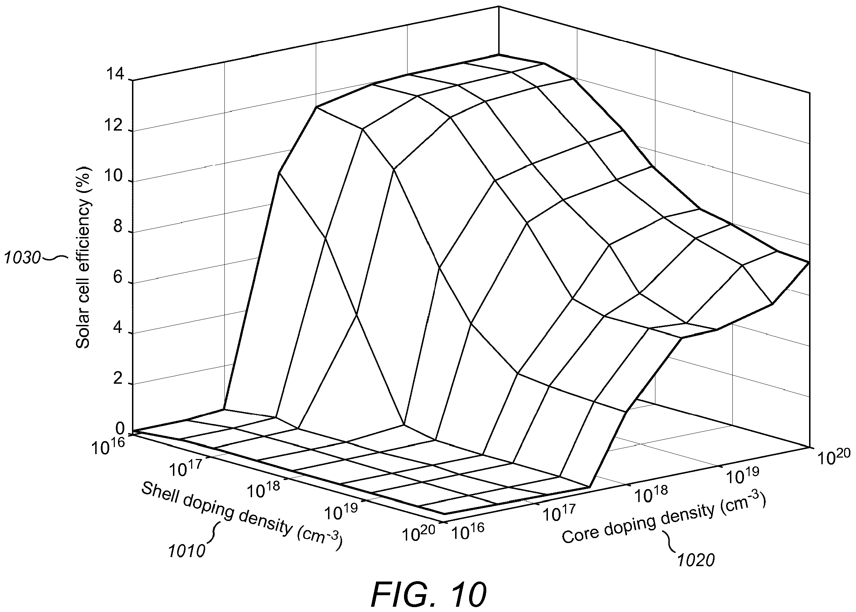

Figure 10 is a chart showing the solar cell efficiencies for a nanowire as a function of both p-type doping density of the core 1020, and n-type doping density of the shell 1010. This chart summarises the findings indicated above and shows generally that higher p-type core doping densities and lower n-type shell doping densities are desirable. In particular, the p-type core doping density should be greater than $10^{17}$cm$^{-3}$ and more preferably at least $10^{18}$cm$^{-3}$ and even more preferably around $10^{19}$ cm$^{-3}$. It also shows that the n-type shell doping density should be low, and preferably less than $10^{17}$cm$^{-3}$ and more preferably around $10^{16}$ cm$^{-3}$ in order to achieve high solar cell efficiencies.

It has also been found from the example simulations illustrated above, that over the range of preferable p-type core and n-type shell doping densities for achieving high solar cell efficiencies, the n-type shells should not be considerably thicker than ~30-40nm, as otherwise carrier-carrier scattering starts to escalates. Therefore, the lightly-doped n-type shell should be as thin as possible to maximise carrier collection efficiency through reduced carrier recombination / carrier-carrier scattering in the shell, and should not be substantially thicker than ~30-40nm. Therefore, the n-type shell is preferably less than 60nm, more preferably 50nm or less, and even more preferably around 30-40nm, depending on the material parameters used.

In nanowire structures were a p-type GaAs core and n-type Al$_x$Ga$_{1-x}$As shell is used, the molar fraction of the Al$_x$Ga$_{1-x}$As may affect the solar cell efficiency of the solar cell. Therefore, with p-type core and n-type shell doping densities kept constant at $10^{19}$cm$^{-3}$ and $10^{16}$cm$^{-3}$ respectively, simulations can be run over a range of Al mole fractions.

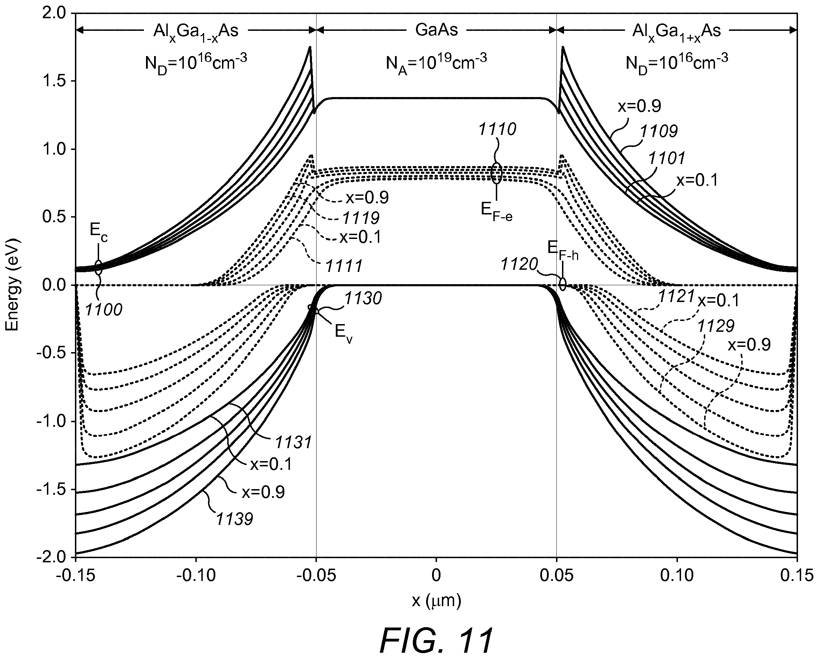

Figure 11 shows energy band diagrams in short-circuit condition over a range of Al mole fractions from x=0.1 to x=0.9. The cluster of solid lines 1100 shows the conduction bands over a range of Al mole fractions, where the lowest line 1101 corresponds to the lowest Al mole fraction of x=0.1 and the highest line 1109 corresponds to the highest Al mole fraction of x=0.9. The solid lines in between 1101 and 1109 shows the progressive change in conduction bands between these extremes of Al mole fraction. The conduction band 1100 shows that at the hetero-junction at $\pm 0.05\mu$m, the conduction band energy barrier increases for higher Al mole fractions.

The cluster of solid lines 1130 shows the valence bands over a range of Al mole fractions, where the highest line 1131 corresponds to the lowest Al mole fraction of x=0.1 and the lowest line 1139 corresponds to the highest Al mole fraction of x=0.9.

The cluster of dotted lines 1110 indicates the quasi-Fermi level energy for electrons ($E_{F-e}$), where the lowest line 1111 has the lowest Al mole fraction of x=0.1 and the highest line 1119 has the highest mole fraction of x=0.9. The diagram also shows the quasi-Fermi level energy for holes $E_{F-h}$ indicated by the cluster of dotted lines 1120, where the highest line 11121 corresponds to the lowest Al mole fraction of x=0.1 and the lowest line 1129 corresponds to the highest Al mole fraction of x=0.9. The two clusters 1110 and 1120 indicates how the quasi-Fermi-level energy splitting increases with Al mole fraction, indicating that carrier collection deteriorates with increasing Al mole fraction, and therefore an increase in electric-field and open-circuit voltage, but a decrease in short-circuit current.

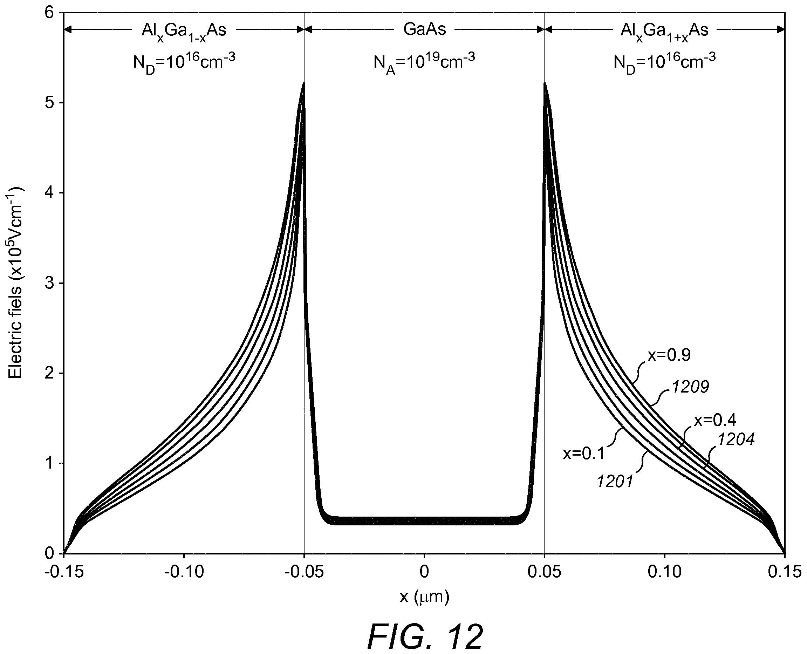

Figure 12 shows the electric field profiles in short-circuit conditions over a range of Al mole fractions in the nanowire shell. Of the cluster of solid lines shown, the lowest line 1201 corresponds to the electric field profile for the lowest Al mole fraction of x=0.1, and the highest line 1209 corresponds to the electric field profile for the highest Al mole fraction of x=0.9. The solid line 1204 corresponds to the electric field profile of an Al mole fraction of x=0.4, but as the solid lines between 1201 and 1209 shows the progressive change in electric fields between these extremes of Al mole fraction, this graph also shows that above an Al mole fraction of x=0.4, further increases in Al mole fraction lead to limited changes in electric field.

The electric field profiles 1201 to 1209 shows an increased Al mole fraction generally leads to higher electric fields, but it also shows that above the Al mole fraction of x=0.4 1204, the increase in electric field is limited due to saturation. This saturation is when the lowest conduction band in Al$_x$Ga$_{1-x}$As goes from $\Gamma$ to the X-point (where $\Gamma$ and X-points are critical points of the Brillouin zone) to become an indirect bandgap, and varies very slowly with increasing x thereafter.

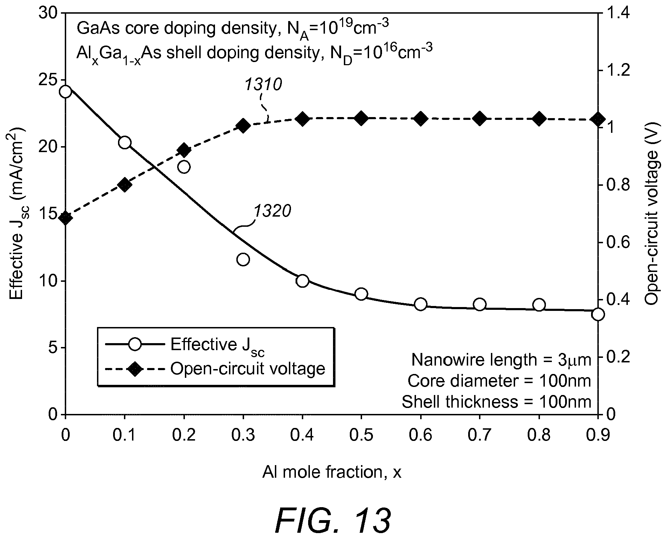

Figure 13 is a graph showing the short-circuit current density and open-circuit voltage as a function of Al mole fraction and illustrates the effect of the saturation observed in Figure 12 from Al fractions in above x=0.4. The open circuit voltage 1310 is shown to increase significantly from x=0 to x=0.4, but above x=0.4 the saturation results in limited to no increase in open-circuit voltage.

Furthermore, the short-circuit current density line 1320 indicates that increasing the Al mole fraction has an adverse effect on the short-circuit current density due to the increase in conduction-band energy barrier at the hetero-junction illustrated in Figure 11.

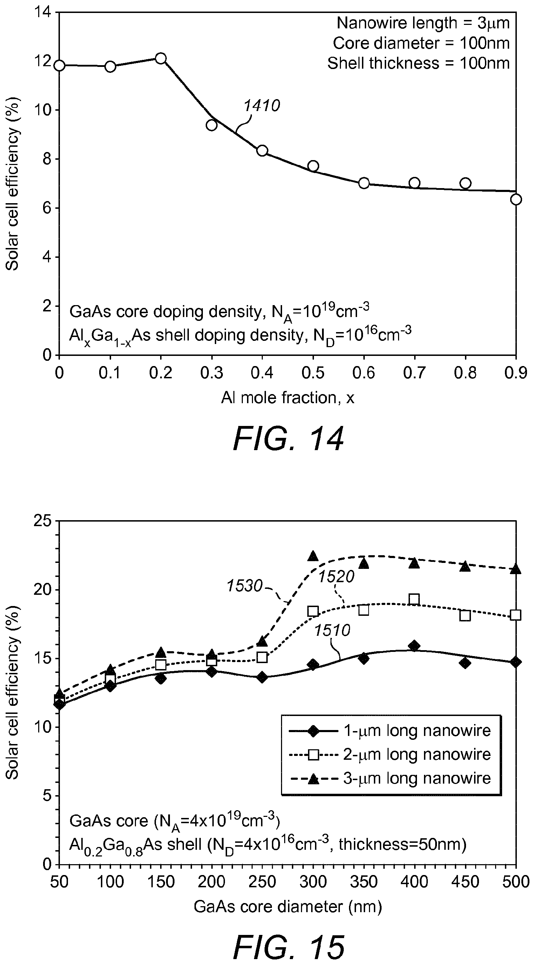

Figure 14 is a graph showing the solar cell efficiency 1410 as a function of Al mole fraction, and illustrates the combined effect of the results observed in Figures 11 to 13. Although the short-circuit current density decreases with Al mole fraction, the effect on solar cell efficiency 1410 is counteracted by the increase in electric-field as the Al mole fraction increases, resulting in a peak at x=0.2, before saturation reduces this effect. Therefore, above an Al mole fraction of x=0.2, the solar cell efficiency is shown to decrease.

The above simulation results indicate that it may be advantageous for the Al mole fraction to be kept low, preferably below x=0.3, more preferably between x=0.1 and x=0.3, and more preferably still at x=0.2.

The dimensions of each nanowire may affect the solar cell efficiency, and therefore simulating different core diameters, shell thickness, and nanowire lengths may be advantageous. Figure 15 is a graph showing solar cell efficiency as a function of p-type core diameter for a range of nanowire lengths. In the simulations illustrated in Figure 15, the p-type core and n-type shell doping densities were kept constant at $4\times10^{19}$cm$^{-3}$ and $4\times10^{16}$cm$^{-3}$ respectively, and the shell thickness and Al mole fraction were fixed at 50nm and x=0.2 respectively.

Solid line 1510 shows how the solar cell efficiency of a nanowire structure varies with a length of 1$\mu$m and p-type core diameters between 50nm and 500nm. Lines 1520 and 1530 similarly show variations in solar cell efficiency over a range of p-type core diameters, but with nanowires of length 2$\mu$m and 3$\mu$m. For a 1$\mu$m nanowire 1510, a first peak of solar cell efficiency is found at a 200nm diameter, with a second, larger peak at a core diameter of 400nm. For a 2$\mu$m nanowire 1520, the solar cell efficiency generally increased with core diameters up to 250nm, where a substantial increase with core diameter starts up to a peak at 400nm. Similarly, for a 3$\mu$m, the solar cell efficiency rises marginally with core diameter up to 250nm, before a sharp rise to a substantial peak between 300nm and 500nm. These simulation results indicate that it may be advantageous for the core diameter to be between 250nm and 500nm, preferably between 300nm and 450nm, and more preferably around 400nm.

The optimum core diameter of 400nm determined from the above simulations may be a result of the spectral overlap between optical modes of the radial p-n junction and the AM1.5G solar spectrum being at its largest, as well as a degree of carrier collection, thereby yielding the optimum absorption and carrier regeneration rates as well as carrier collection efficiency.

Figure 15 also shows that increasing the length of nanowire from 1$\mu$m to 3$\mu$m results in an increase in an solar cell efficiency, indicating a relationship between the length of the nanowire and solar cell efficiency. Using appropriate nanowire lengths would allow the spectral components of the AM1.5G solar spectrum overlapping the optical modes of the nanowire to be maximally absorbed to yield the optimum solar cell efficiency for the radial p-n junction, as heavily doped p-type cores have extended absorption bandwidth as a result of bandgap shrinkage. To determine optimum nanowire lengths, simulations may be run keeping p-type core doping density, n-type shell doping density, shell thickness, Al mole fraction, and core diameter constant at $4\times10^{19}$cm$^{-3}$, $4\times10^{16}$ cm$^{-3}$, 50nm, x=0.2, and 400nm, respectively, for example.

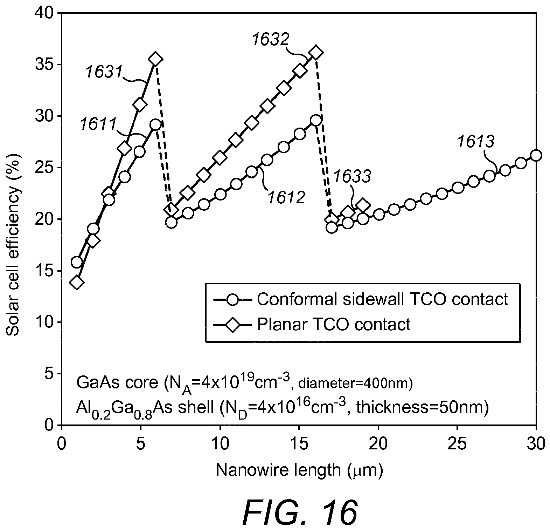

Figure 16 is a graph showing the solar cell efficiency as a function of nanowire lengths between 1$\mu$m and 30$\mu$m, and also illustrates the difference between using a conformal and planar TCO contact. Sections 1611 and 1631 show that increasing the nanowire length from 1$\mu$m to 6$\mu$m results in a rapid increase in solar cell efficiency as a result of increased optical absorption of deep penetration AM1.5G solar spectral components. However, there is a considerable drop in solar cell efficiency illustrated between nanowire lengths 6$\mu$m and 7$\mu$m due to severe hole pile ups in the p-type core causing excessive non-radiative carrier recombination.

Subsequent increases in nanowire length from 7$\mu$m to 17$\mu$m (1612 and 1632) results in similar increases in solar cell efficiencies until a second severe hole pile up at 17$\mu$m. This cycle is shown to repeat itself with progressively decreasing rates of increase in solar cell efficiency as illustrated by the lower gradient of lines 1613 and 1633, as the intensity of AM1.5G solar spectral components within the absorption band of the p-type core weakens as they penetrate axially through the nanowire. The rate of increase in solar cell efficiency with increasing nanowire length would eventually become negative when the nanowire length is considerably longer than the length that fully absorbs all the AM1.5G solar spectral components within the absorption bands.

Figure 16 also illustrates the differences in solar cell efficiency between nanowire structures with conformal sidewall TCO contacts (see 250 of Fig 2A) and planar TCO contacts (see 256 of Fig 2B). The graph shows that solar cells with a planar TCO contact have higher solar cell efficiencies than those with conformal TCO contacts, except for cases where the nanowire is 1$\mu$m to 2$\mu$m long.

The increase in solar cell efficiency with increasing nanowire length for the planar TCO contact cases are steeper compared to those for the conformal sidewall TCO contact cases. With the planar TCO contacts, the solar cell efficiency peaks at roughly 14.1% for a 6$\mu$m-long nanowire compared to the 13.7% efficiency for the conformal TCO

contact at 6μm. Increasing the lengths from 6μm to 7μm may result in a drop in solar efficiency to 9.7% and 9.5% for conformal and planar contacts respectively.

Planar TCO contacts perform better than conformal sidewall TCO contact because planar TCO contacts do not suffer from severe band-bending effects which limit carrier dynamics/transport and photon recycling efficiency like conformal sidewall TCO contacts do.

At lower nanowire lengths (1μm and 2μm) solar cell efficiencies are lower with planar TCO contacts because the electrons generated by high-energy photons cannot be collected as efficiently as in the case of a conformal sidewall TCO contact due to the shorter lifetimes of higher energy electrons. At these shorter lengths, planar TCO contacts have a lower effective current density than solar cells with conformal TCO contacts.

Although planar TCO contacts may lead to slightly higher open-circuit voltages than solar cells with conformal TCO contacts, it would not be sufficient to compensate for the loss of the electrons generated by high-energy photons. The slightly higher open-circuit voltages in solar cells with a planar TCO contact is because of the significantly higher radiative, Auger, and SRH recombination rates in the core and shell, and the higher radiative recombination rate (in the core and shell) and Auger recombination rate (in the core) causing the electron quasi-Fermi-level energy in the core to increase in solar cells with planar TCO contacts.

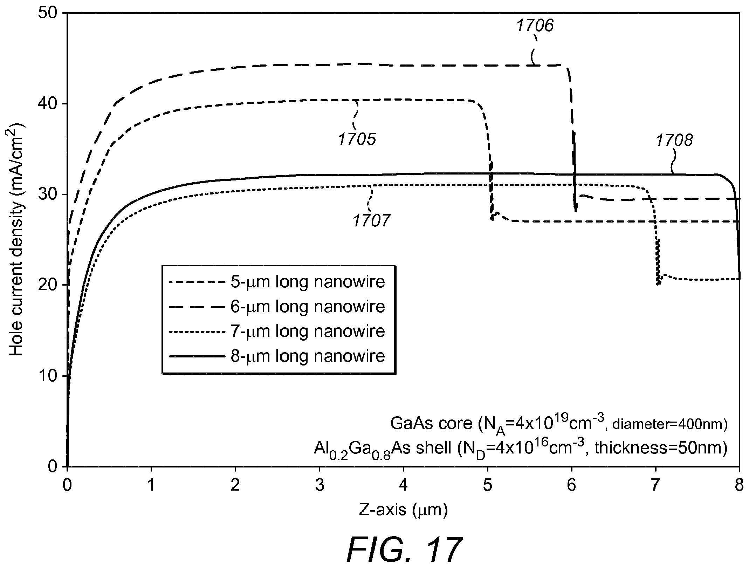

The severe hole pile up observed in Figure 16 is illustrated in Figure 17 which shows axial profiles of the hole current densities for nanowire lengths of 5μm 1705, 6μm 1706, 7μm 1707, and 8μm 1708. The change from the 5μm line 1705 and 6μm line 1706 shows that there is no sign of sever hole pile up from the increase in nanowire length, and the longer length led to an increase in hole current density. However, the change from the 6μm line 1706 and 7μm line 1707 shows a significant decrease in hole current density, indicating a hole pile up with its effects propagating through the entire length of the nanowire, as shown by the axial profile.

A further increase of nanowire length from 7μm 1707 to 8μm 1708 shows an increase in hole current density as the nanowire builds up the photo-generated carrier population through absorption of AM1.5G solar spectral components having low absorption coefficients. As these additional photo-generated holes are generated within 1μm from the p-type substrate, those holes are readily swept out of the p-type core to the p-type substrate and out of the bottom contact to the external circuitry leading to an increase in hole current density at equilibrium and therefore does not contribute to the severe hole pile-up. The additional photo-generated electrons move readily from the p-type core to the n-type shell, flowing out of the top contact to the external circuitry.

From the above simulation results, it may be advantageous to restrict the nanowire length to certain values. It may therefore be preferably to restrict the nanowire length, particularly the p-type core length to one of the peaks determined in the simulations indicating the longest local lengths before severe hole pile up. The nanowire length is selected from at least one of the ranges 5 to 7μm and 15 to 17μm, and preferably selected from at least one of the ranges 5 to 6μm and 15 to 16μm, and more preferably selected from one of 6μm and 16μm, and more preferably still 6μm.

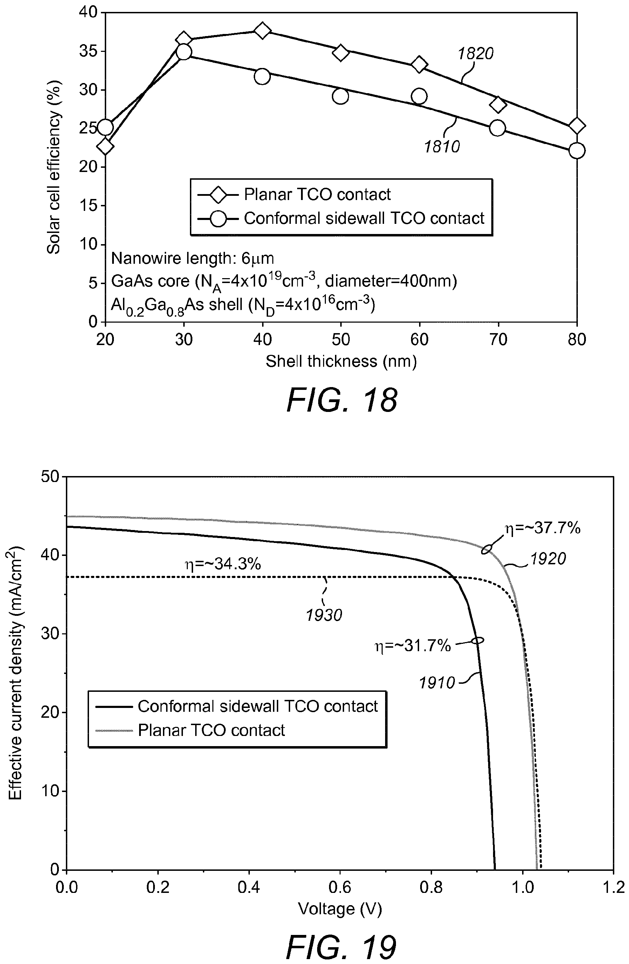

Figure 18 illustrates the effects of shell thickness on the solar cell efficiencies. Line 1810 shows the relationship between shell thickness and solar cell efficiency for cells with conformal TCO contacts, while line 1820 shows the relationship when planar TCO contacts are used. Line 1810 and line 1820 show that thinner shells yield higher solar cell efficiencies but eventually drop considerably when the optical modes of the nanowire become leaky. This leakiness may be because the shells are too thin to effectively confine light in the nanowire, resulting in the optical modes deviating from the optimal point. The optical modes of a $GaAs/Al_{0.2}Ga_{0.8}As$ core-shell nanowire become unstable when the shell thickness is 30 nm, and the solar cell efficiency falls steeply for shells thinner than 30 nm. Hence, the thinnest shell for radial p-n junction $GaAs/Al_{0.2}Ga_{0.8}As$ core-shell nanowire solar cells with either a conformal sidewall or planar TCO contact may be around 40 nm.

At shell thicknesses of 20 nm or below, the solar cell efficiency of a solar cell with a planar TCO contact 1820 falls below that of a solar cell with a conformal sidewall TCO contact 1810 because the re-emitted photons from the core penetrate through the optically leaky shell without generating any electron-hole pair in the shell. Consequently, the current density in solar cells with a planar TCO contact (whereby the conduction-band energy barrier at the $GaAs/Al_{0.2}Ga_{0.8}As$ interface is considerably higher) is lower than that of solar cell with a conformal sidewall TCO contact when the shell thickness is 20 nm, leading to lower solar cell efficiency.

In another example a 6μm length nanowire with a conformal sidewall contact, a 400nm diameter GaAs core with p-type doping of $6\times10^{18}cm^{-3}$, and an $Al_{0.2}Ga_{0.8}As$ shell with an n-type doping density of $3\times10^{16}cm^{-3}$ is simulated. The solar efficiency of the nanowire increases as the shell is made thinner, reaching a solar efficiency peak of 14.4% at 40nm thickness before falling sharply to around 11% solar efficiency at thinner shells. In another example a 6μm length nanowire with a planar contact, a 400nm diameter GaAs core with p-type doping of $7\times10^{16}cm^{-3}$, and an $Al_{0.2}Ga_{0.8}As$ shell with an n-type doping density of $10^{16}cm^{-3}$ is simulated. Here, the shell becomes fully ionised when the shell is thinner than 48nm, therefore the highest solar cell efficiency in this example is 14.4% when the shell is 48nm thick.

Figure 19 illustrates the effective J-V characteristics (relationship between effective current density and voltage) for solar cells with a 6μm long nanowire, 400nm diameter GaAs core ($N_A=4\times10^{19}cm^{-3}$), 40nm thick $Al_{0.2}Ga_{0.8}As$ shell

($N_D=4\times10^{18}$cm$^{-3}$), with either a conformal TCO contact (indicated by line 1910) or a planar TCO contact (indicated by line 1920). The nanowire with a planar TCO contact exhibits an effective short-circuit current density of roughly 45.1 mA/cm$^2$ and an open-circuit voltage of roughly 1.03 V, while the nanowire with a conformal TCO contact exhibits an effective short-circuit current density of roughly 43.7 mA/cm$^2$ and an open-circuit voltage of roughly 0.94 V.

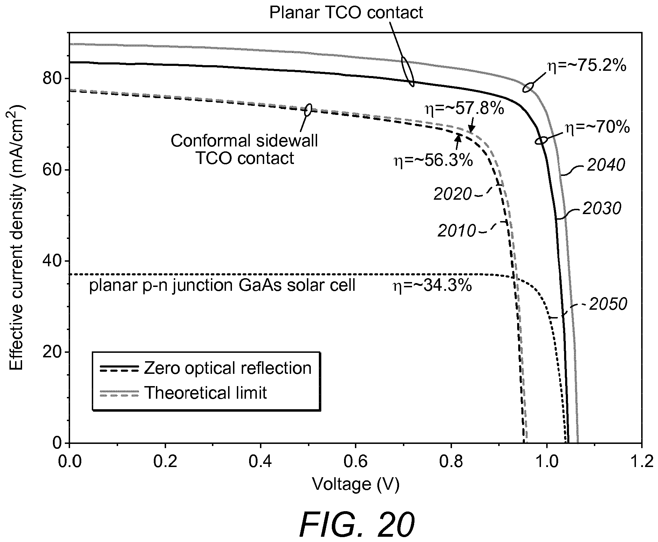

Figure 20 illustrates the effect of optical reflection loss by showing the J-V characteristics for an ideal case with no optical reflection loss. The graph is directed to solar cells with a 6μm long nanowire, 400nm diameter GaAs core ($N_A=4\times10^{19}$cm$^{-3}$), 40nm thick $Al_{0.2}Ga_{0.8}As$ shell ($N_D=4\times10^{18}$cm$^{-3}$). The graph shows the J-V characteristics of a cell with a conformal TCO contact with zero optical reflection 2010 and the theoretical limit 2020, as well as the J-V characteristics of a cell with a planar TCO contact with zero optical reflection 2030 and the theoretical limit 2040. The theoretical limit is considered where there is neither carrier recombination nor optical reflection loss.

For a cell with a planar TCO contact and zero optical reflection 2030 the effective short-circuit current density and open-circuit voltage are roughly 83.6mA/cm$^2$ and 1.05V respectively. This is due to the ability to collect high-energy or hot electrons which is made possible by a high electric field and lightly-doped thin shell that minimizes carrier-carrier scattering loss as well as the strong optical confinement of the nanowire optical modes, which gives rise to intrinsically high photon-recycling and carrier generation rates, For a cell with a planar TCO contact at the theoretical limit 2040 the effective short-circuit current density and open-circuit voltage are roughly 87.6mA/cm$^2$ and 1.07 V respectively.

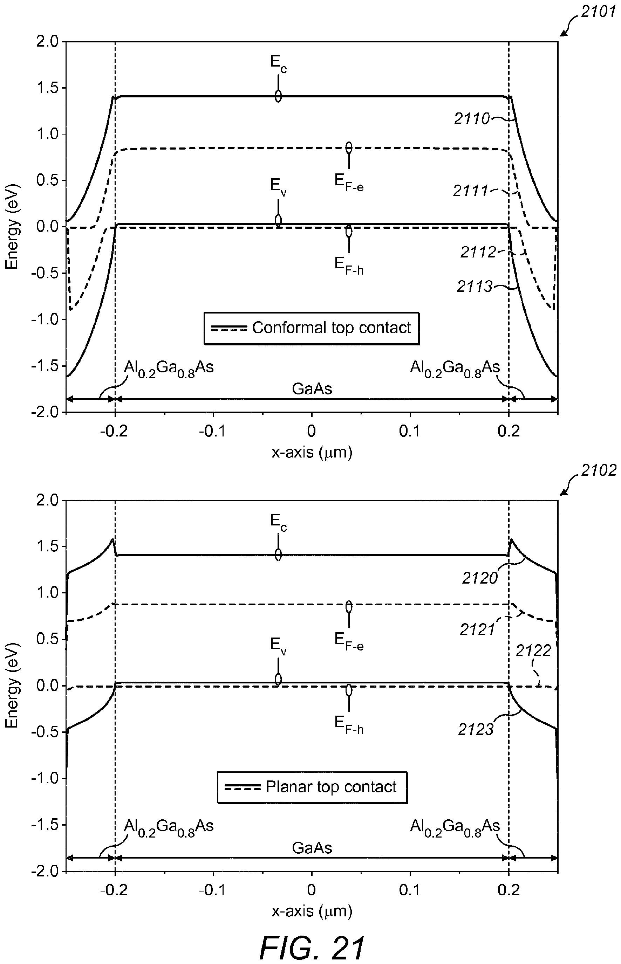

Figure 21 shows the results of simulating the energy band diagrams in short-circuit conditions for cells with conformal top contacts and planar contacts. In the example simulations presented in Figure 21, the nanowire has length 6μm, the $Al_{0.2}Ga_{0.8}As$ shell has a doping density of $4\times10^{16}$cm$^{-3}$ and thickness of 50nm, and the GaAs core has a doping density of $4\times10^{19}$cm$^{-3}$ and a diameter of 400nm.

The energy band diagram for a solar cell with a conformal TCO contact is shown in 2101. The line 2110 shows the conduction band $E_c$ along the profile of the radial p-n junction and line 2113 shows the valence band $E_v$ along the profile of the radial p-n junction. Quasi-Fermi level energy splitting is indicated in graph 2101 with line 2111 indicating the quasi-Fermi level energy for electrons ($E_{F-e}$) and line 2112 indicating the quasi-Fermi level energy for holes ($E_{F-h}$). Similarly, in graph 2102, lines 2120, 2121, 2122 and 2133 shows $E_c$, $E_{F-e}$, $E_{F-h}$, and $E_v$ respectively for a solar cell with a planar TCO contact.

As shown in graphs 2101 and 2102, the conduction energy barrier at the GaAs/$Al_{0.2}Ga_{0.8}As$ interface is considerably higher with the planar TCO contact, and the band bending in the conformal TCO contact 2101 is lifted with the planar TCO contact 2102. Furthermore, with a planar TCO contact the electron quasi-Fermi-level energy in the shell is considerably higher and the dip of the hole quasi-Fermi-level energy in the shell is very small. These properties suggest more efficient carrier transport in solar cells with planar TCO contacts compared to those with conformal TCO contacts.

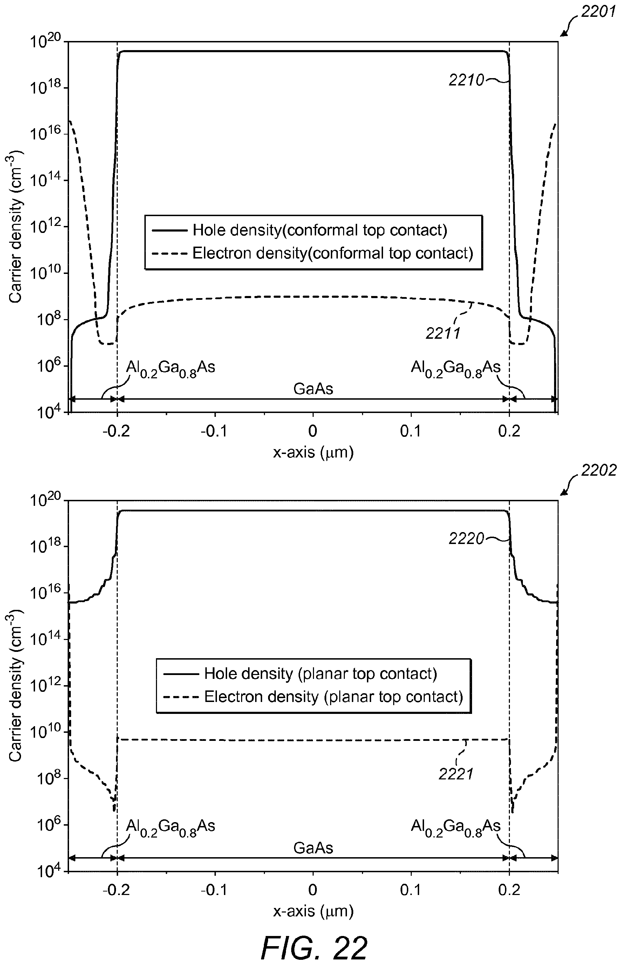

Figure 22 shows how the carrier densities vary across the profile of a radial p-n junction for solar cells with a conformal TCO contact (graph 2201) and a planar TCO contact (graph 2202). The properties of the nanowire simulated in Figure 22 are the same as those in the nanowire simulated in Figure 21. Lines 2210 and 2220 show the hole densities across the profile for solar cells with conformal and planar TCO contacts respectively, and lines 2211 and 2221 show the electron densities across the profile for solar cells with conformal and planar TCO contacts respectively.

The graphs 2201 and 2202 show that the hole densities at the shell and the electron densities at the core are much higher with the planar TCO contact than the conformal TCO contact. The higher conduction-band energy barrier at the GaAs/$Al_{0.2}Ga_{0.8}As$ interface in solar cell with a planar TCO contact increases the electron density in the core resulting in higher recombination rates in the core and gives rise to a higher photon recycling efficiency.

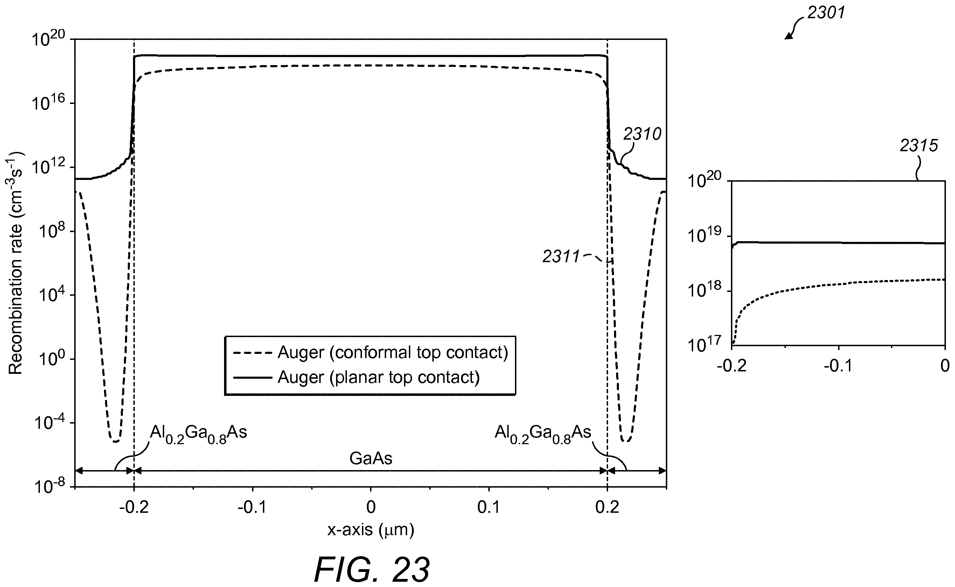

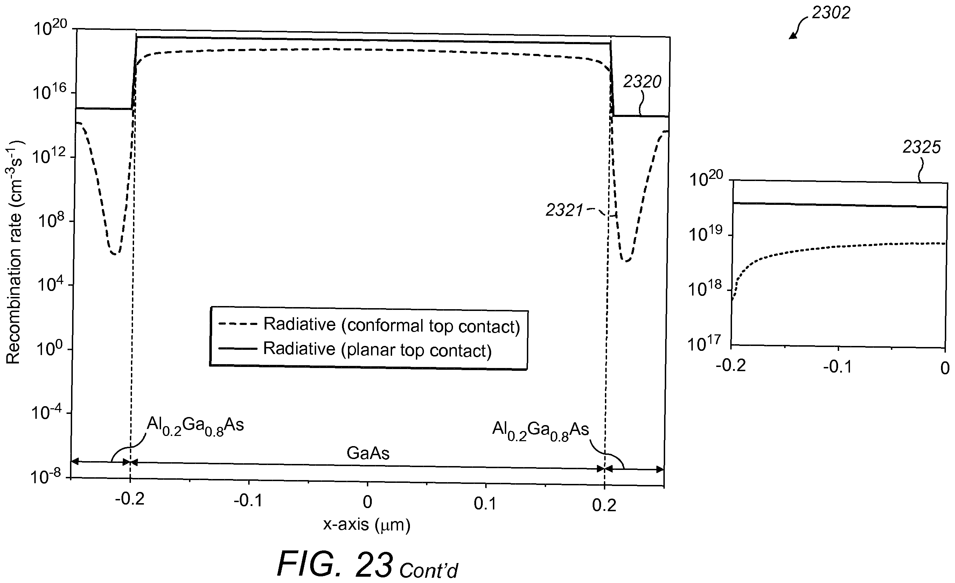

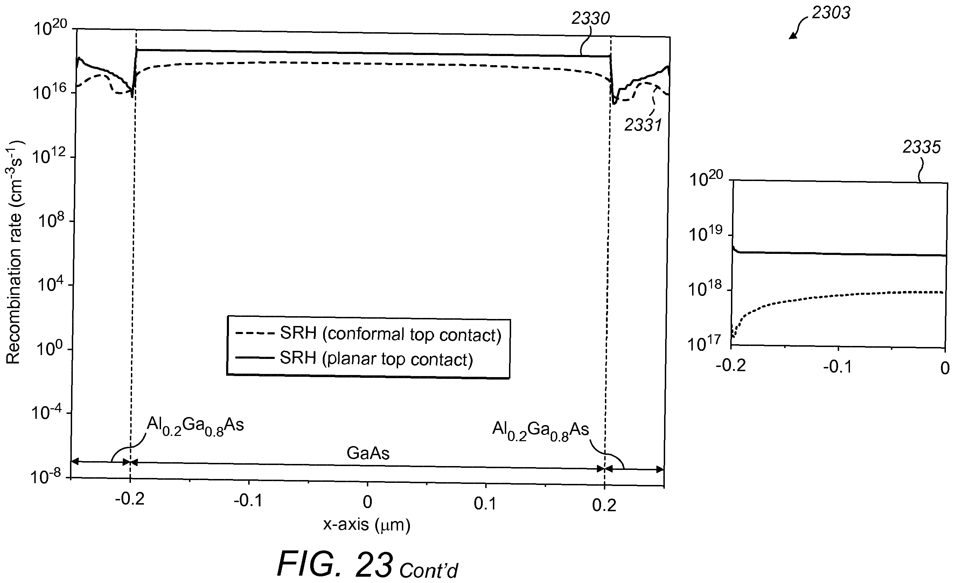

Figure 23 shows the recombination rates along the profiles for solar cells with conformal and planar TCO contacts having the same properties as the solar cells simulated in Figures 21 and 22. Specifically graph 2301 shows the Auger recombination rates for solar cells with conformal (line 2311) and planar (line 2310) TCO contacts, and inset 2315 provides a magnified view of the graph 2301 for values on the x-axis between -0.2μm and 0μm. Similarly, graph 2302 shows the radiative recombination rates for solar cells with conformal (line 2321) and planar (line 2320) TCO contacts, graph 2303 shows the Shockley-Read-Hall (SRH) recombination rates for solar cells with conformal (line 2331) and planar (line 2330) TCO contacts, and insets 2325 and 2335 are also provided.

In each of graphs 2301, 2302 and 2303 it can be seen that the carrier recombination rates are substantially higher in solar cells with planar TCO contacts.

The higher radiative recombination rate in the core leads to higher hole density in the shell through absorption of re-emitted photons from the core in solar cells with a planar TCO contact and contributes to the electron current. The higher hole density in the shell in turn leads to higher carrier recombination rates in the shell whereby the higher radiative recombination rate increases photon recycling.

As a result of the higher radiative (in both the core and shell) and Auger (in the core) recombination rates, the electron quasi-Fermi-level energy in the core increases and leads to a higher open-circuit voltage in solar cells with a planar TCO contact.

Although there is a considerably higher conduction-band energy barrier at the GaAs/$Al_{0.2}Ga_{0.8}As$ interface in solar cells with a planar TCO contact, the effective current density for nanowires longer than 2μm is still higher than solar cells with a conformal sidewall TCO contact due to better photon recycling in the shell as a result of the absorption of re-emitted photons from the core. This indicates that although carrier recombination rates in the shell in solar cells with a planar TCO contact are higher than solar cells with a conformal sidewall TCO contact, the carrier collection and photon recycling efficiencies of solar cells with a planar TCO contact are higher than that of solar cells with a conformal sidewall TCO contact.

The solar cell efficiency of a photovoltaic device utilising these nanowires may reach higher solar power conversion efficiencies by optimising the packing ratio of the nanowires to improve light trapping / concentrating / confining effects and reducing reflection by applying anti-reflective coatings.

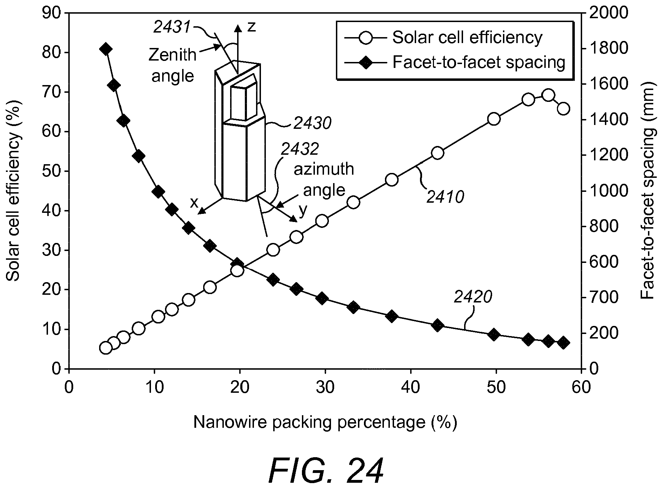

To optimise the packing ratio of the nanowires in an array, further simulations have been made. Figure 24 shows how the packing percentage of nanowires in a nanowire array affects the solar efficiency. In the simulation shown in Figure 24, a hexagonal nanowire with a planar TCO contact, embedded in $Si_3N_4$ (chosen for its heat spreading capability and refractive index matching with the TCO such as ZnO to minimise optical reflection loss), and with the optimised properties indicated above was used. The pitch length in the nanowire array is varied in the simulations to investigate the degree of light trapping and the solar cell characteristics as a function of the nanowire packing percentage.

The graph of Figure 24 shows that the solar cell efficiency 2410 increases linearly with packing percentage. The graph also shows how the facet-to-facet spacing 2420 between adjacent nanowires changes with packing percentage. When the facet-to-facet spacing between adjacent nanowires is roughly 160nm-174nm, in the example simulation provided, sunlight is very strongly trapped in the nanowire array and an optimum solar efficiency is achieved.

Reducing the facet-to-facet spacing below 174nm causes the solar efficiency to saturate and decrease as a result of increased diffraction loss, preventing sunlight from entering the space between the nanowires. In the example simulation, the solar efficiency drops to less than 38% when the pitch length is too small to allow any sunlight to enter the space between nanowires.

Even at packing percentages as low as 8%, results in a solar efficiency of 10%, which is comparable to the current reported solar cell efficiencies of core-shell nanowire arrays. Therefore, packing percentages are preferably greater than 8%. The packing percentages are more preferably higher than 20%, and even more preferably near the point at which solar efficiencies start to drop due to increased diffraction losses, which in this example is at 53.9%.

The simulation of Figure 24 are performed with incident angles for AM1.5G sunlight at 25° zenith angle and 0° azimuth angle. The zenith angle 2431 is taken as the angle relative to the nanowire's 2430 vertical z-axis. The azimuth angle 2432 is taken as the horizontal angle between the incident sun ray and the normal of a side facet of the hexagonal nanowire 2430.

In another example, simulations are performed with incident angles for AM1.5G sunlight at 60° zenith angle and 0° azimuth angle on a 6$\mu$m length nanowire with a planar TCO contact, a 400nm diameter GaAs core with p-type doping of $7 \times 10^{16} cm^{-3}$, and an $Al_{0.2}Ga_{0.8}As$ shell with an n-type doping density of $10^{16} cm^{-3}$. In this example, the solar cell efficiency increases with increasing nanowire package percentage but decreases significantly when the spacing between the nanowires falls below the diffraction limit case as a result of increasingly large diffraction loss. When the nanowires are spaced 160nm apart, and the packing percentage is roughly 57.2%, a peak solar efficiency of 33.4% is achieved. When the spacing is smaller than 160nm, the solar efficiency drops significantly (down to 23.9% solar efficiency at a spacing of 150nm).

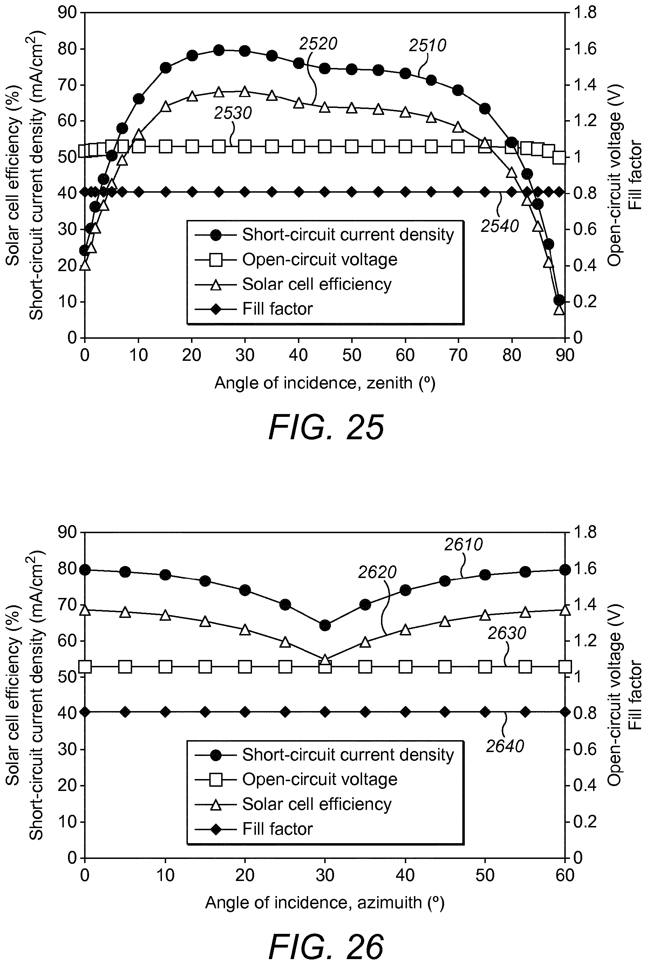

The incident angles of sunlight on the nanowire array solar cell can have a considerable influence on the trapping of sunlight. Figure 25 illustrates how the zenith angle of sunlight affects the short-circuit current density 2510, the solar cell efficiency 2520, the open-circuit voltage 2530 and the fill factor 2540, of the optimised nanowire array with a packing percentage of 53.9% and an azimuth angle of 0°. The graph shows that the zenith angle should be within 15° and 65° in order to achieve high solar cell efficiencies. For incident angles below 15° and above 75°, the solar cell efficiency falls steeply at 0° and 89°, respectively. This is the result of higher reflection loss which reduces the short-circuit current density from between 71 mA/cm$^2$ to 80 mA/cm$^2$ for the range of incident angles from 15° to 65° to 24.3 mA/cm$^2$ and 10.1 mA/cm$^2$ for incident angles at 0° and 89°, respectively. The open-circuit voltage and fill factor remain relatively consistent throughout the range of incident angles between 0° and 89°.

As the nanowires are hexagonal in shape, the azimuth angle of the incident sun rays should also affect the characteristics of the nanowire array solar cell. Figure 26 illustrates how the azimuth angle of sunlight affects the short-circuit current density 2610, the solar cell efficiency 2620, the open-circuit voltage 2630 and the fill factor 2640, of the optimised nanowire array with a packing percentage of 53.9% and an zenith angle of 25°.

The short-circuit current density is shown to be at a maximum of about 79.6 mA/cm$^2$ at an azimuth angle of 0° when the sun is in-line with the normal of a side facet of the hexagonal nanowire. The current density is shown to gradually dip to a minimum of roughly 64.5 mA/cm$^2$ as the azimuth angle increases to 30°, where the sun is in-line with two directly opposite corners of the hexagonal wires, before rising to another maximum at 60°. As a result of this variance in short-circuit current density with azimuth angle, the solar cell efficiency also falls and rises. The open-circuit voltage and fill factor remain relatively consistent over the range of azimuth angles.

The simulations illustrated in Figures 25 and 26 show that the optimized nanowire array solar cell exhibits a high solar efficiency over a wide range of zenith angles and over all azimuth angles.

In another example, simulations are performed on nanowires with a planar TCO contact for determining the effect of changing zenith and azimuth angles. For solar cells with a planar TCO contact, the short-circuit current density increases steeply over a range of zenith angles 0° to 10° as light is concentrated onto the nanowires from the side. Over the range of zenith angles from 10° to 75°, the short-circuit current density saturates and decreases gradually to another plateau as a result of the increasing optical reflection loss at the surface of the planar TCO contact, and corresponding decrease in optical reflection loss and illumination length at the nanowire side facets. For zenith angles above 75°, the short-circuit current density declines steeply due to increasingly high optical reflection loss at the surface of the planar TCO contact and short illumination length of the nanowire side facets.

The open-circuit voltage stays essentially constant apart from a slight roll-off for zenith angles ranging from 0° to 10°, and 75° to 89°. The slight change in open-circuit voltage is due to a small change in uncollected carriers, thereby changing the built-in electromotive force marginally. Similarly, the fill-factor remains essentially constant apart from a slight increase for zenith angles ranging from 0° to 10°, and 75° to 89°.

While the solar efficiencies plotted in Figure 25 are based on the illuminated wafer surface area, a better calculation for solar efficiency would be based on the actual absorption area. The absorption-based solar efficiency increases considerably from 2.5% to 28.5% over zenith angles 1° to 30° respectively, as less sunlight is reflected off the nanowire side facets, thereby increasing the amount of sunlight absorbed in the nanowires.

For zenith angles ranging from 35° to 70°, the absorption-based solar efficiency saturates between 29.6% and 31.8% when the decreasing optical reflection loss at the air/cell interfaces. Beyond a zenith angle of 70°, the absorption-based solar efficiency steeply declines due to the increasingly large optical reflection loss at the air/cell interface. Therefore, the highest absorption-based solar efficiency in this example with a nanowire spacing of ~174nm is 31.8% where the zenith and azimuth angles are 60° and 0° respectively.

Like the earlier example, the azimuth angle of incident light has negligible effects on the open-circuit voltage and fill-factor, which remain mostly unchanged at 0.93V and 0.73 respectively. The short-circuit current density does dip gradually to a minimum of 45mA/cm$^2$ at 30° from a maximum of 58.8mA/cm$^2$. Therefore, the absorption-based solar efficiency falls and rises between 26% and 31.8% as the azimuth angle varies.

In one example, a solar efficiency of 33.4% is achieved for a nanowire structure with an array of nanowires with a planar TCO contact and the following parameters: 400nm diameter p-type GaAs core with doping density $7 \times 10^{16}$cm$^{-3}$, and a 50nm thick n-type Al$_{0.2}$Ga$_{0.8}$As shell around the core with a doping density $10^{16}$cm$^{-3}$, a nanowire length of 6$\mu$m, a facet-to-facet spacing of 160nm, a packing percentage of 57.2%, a 0° azimuth angle of incident light, and a 60° zenith angle of incident light. This solar cell efficiency is high for single p-n junction GaAs solar cells, as it surpasses the -28-29% solar cell efficiency achieved with the current best single-junction planar thin-film GaAs solar cells, and substantially exceeds the efficiencies of current radial p-n junction solar cells with efficiencies of less than 10%.

While the above combination of parameters may lead to an optimum solar cell efficiency, each of the individual parameter ranges indicated lead to their own improvements in solar cell efficiency. The different parameters defined may be used together or in isolation to improve on solar cell efficiencies of radial p-n junction solar cells.

While computational simulation methods exist for determining characteristics of p-n junctions, novel and inventive considerations have been made when designing the simulations resulting in a plurality of surprising and useful results. The computational requirements for accurately calculating the parameters of the proposed solution are inhibitively large, and therefore the skilled person must make specific choices as to what estimations are appropriate, which physical effects should be included in the model, what modelling system to use and what meshes to use, for example. Previous attempts to model such systems have resulted in inconsistent and uncorrelated results given to inappropriate choices such as the wrong mesh for a given large parameter space. It is only with considerable knowledge over a broad range of fields in semiconductor device physics and computational modelling, and by overcoming the preconceptions and prejudices associated with known design trends in planar thin-film solar cells that the consistent and surprising results of the proposed solution have been found.

It is to be understood that the present disclosure includes permutations of combinations of the optional features set out in the embodiments described above. In particular, it is to be understood that the features set out in the appended dependent claims are disclosed in combination with any other relevant independent claims that may be provided, and that this disclosure is not limited to only the combination of the features of those dependent claims with the independent claim from which they originally depend.

**Claims**

1. A photovoltaic device comprising at least one nanowire structure fixed to a substrate (110, 210), wherein each of the at least one nanowire structures comprises:

a heavily doped p-type core (120, 220) having a proximal end fixed to the substrate (110, 210) and a distal end extending away from the substrate (110, 210); and

a lightly doped n-type shell (130, 230) around the p-type core (120, 220) so as to form a radial p-n junction;

wherein the p-type core (120, 220) is formed of GaAs and the n-type shell (130, 230) is formed of $Al_xGa_{1-x}As$, wherein x has a value of less than or equal to 0.2;

wherein the doping density of the n-type shell (130, 230) is less than $10^{17}$ cm$^{-3}$; and

wherein the doping density of the p-type core (120, 220) is greater than $10^{18}$ cm$^{-3}$.

2. The photovoltaic device of claim 1, wherein the doping density of the p-type core (120, 220) is $10^{19}$ cm$^{-3}$.

3. The photovoltaic device of any preceding claim, wherein the doping density of the n-type shell (130, 230) is $10^{16}$ cm$^{-3}$.

4. The photovoltaic device of any preceding claim, wherein the n-type shell (130, 230) has a thickness of between 20nm and 50nm, and preferably 30nm; and/or

wherein the diameter of the p-type core (120, 220) is greater than 300nm, and preferably 400nm.

5. The photovoltaic device of any preceding claim, wherein the length of the nanowire is between $5\mu$m and $7\mu$m, and preferably $6\mu$m.

6. The photovoltaic device of any preceding claim, wherein the substrate (110, 210) comprises silicon; and/or

wherein the substrate comprises a graphitic layer.

7. The photovoltaic device of any preceding claim, wherein the distal end of the nanowire comprises an anti-reflection coating.

8. The photovoltaic device of any preceding claim, wherein each of the at least one nanowire structures are coated in a transparent conductive oxide (TCO) (150, 250).

9. The photovoltaic device of any of claims 1 to 7 further comprising a planar TCO contact (256) above the at least one nanowire structures.

10. The photovoltaic device of claim 1, wherein the p-type core (120, 220) has a radius greater than 300nm, preferably 400nm, and is formed of GaAs with a doping density greater than $10^{18}$ cm$^{-3}$, preferably $10^{19}$ cm$^{-3}$, the n-type shell (130, 230) has a thickness of less than 50nm, preferably 40nm, and is formed of $Al_{0.2}Ga_{0.8}As$ with a doping density less than $10^{17}$ cm$^{-3}$, preferably $10^{16}$ cm$^{-3}$, and the nanowire structure has a length of larger than $5\mu$m, preferably between $5\mu$m and $7\mu$m, and more preferably $6\mu$m.

11. A solar cell comprising a plurality of the photovoltaic devices of any of claims 1 to 10, wherein the plurality of photovoltaic devices are arranged in an array with a packing percentage between 50 and 55%.

12. A photovoltaic device according to claim 1, further comprising a planar TCO contact (256) above the at least one nanowire structures, wherein insulating polymer (255) surrounds each of the at least one nanowire structures and fills the gaps between the nanowire structures.

13. A method of fabricating a photovoltaic device comprising at least one nanowire grown on a substrate (110, 210), the method comprising:

growing a nanowire comprising a heavily doped p-type core (120, 220) having a proximal end fixed to the substrate (110, 210) and a distal end extending away from the substrate, and an n-type shell (130, 230) around the p-type core (120, 220), such that the fabricated photovoltaic device is a photovoltaic device according to any of claims 1 to 10.

**Patentansprüche**

1. Photovoltaikvorrichtung, die wenigstens eine Nanodrahtstruktur umfasst, die an einem Substrat (110, 210) befestigt ist, wobei jede der wenigstens einen Nanodrahtstruktur Folgendes umfasst:

einen stark dotierten Kern (120, 220) vom p-Typ, der ein proximales Ende, das an dem Substrat (110, 210) befestigt ist, und ein distales Ende aufweist, das sich von dem Substrat (110, 210) weg erstreckt; und

eine leicht dotierte Hülle (130, 230) vom n-Typ um den Kern (120, 220) vom p-Typ herum, um einen radialen pn-Übergang auszubilden;

wobei der Kern (120, 220) vom p-Typ aus GaAs ausgebildet ist und die Hülle (130, 230) vom n-Typ aus $Al_xGa_{1-x}As$ ausgebildet ist, wobei x einen Wert von kleiner oder gleich 0,2 aufweist;

wobei die Dotierungsdichte der Hülle (130, 230) vom n-Typ weniger als $10^{17}$ $cm^{-3}$ beträgt; und

wobei die Dotierungsdichte des Kerns (120, 220) vom p-Typ über $10^{16}$ $cm^{-3}$ beträgt.

2. Photovoltaikvorrichtung nach Anspruch 1, wobei die Dotierungsdichte des Kerns (120, 220) vom p-Typ $10^{19}$ $cm^{-3}$ beträgt.

3. Photovoltaikvorrichtung nach einem der vorhergehenden Ansprüche, wobei die Dotierungsdichte der Hülle (130, 230) vom n-Typ $10^{16}$ $cm^{-3}$ beträgt.

4. Photovoltaikvorrichtung nach einem der vorhergehenden Ansprüche, wobei die Hülle (130, 230) vom n-Typ eine Dicke zwischen 20 nm und 50 nm und bevorzugt 30 nm aufweist; und/oder
wobei der Durchmesser des Kerns (120, 220) vom p-Typ über 300 nm und bevorzugt 400 nm beträgt.

5. Photovoltaikvorrichtung nach einem der vorhergehenden Ansprüche, wobei die Länge des Nanodrahts zwischen 5 $\mu$m und 7 $\mu$m und bevorzugt 6 $\mu$m beträgt.

6. Photovoltaikvorrichtung nach einem der vorhergehenden Ansprüche, wobei das Substrat (110, 210) Silizium umfasst; und/oder
wobei das Substrat eine graphitische Schicht umfasst.

7. Photovoltaikvorrichtung nach einem der vorhergehenden Ansprüche, wobei das distale Ende des Nanodrahts eine Antireflexionsschicht umfasst.

8. Photovoltaikvorrichtung nach einem der vorhergehenden Ansprüche, wobei jede der wenigstens einen Nanodrahtstruktur mit einem transparenten leitfähigen Oxid (transparent conductive oxide - TCO) (150, 250) beschichtet ist.

9. Photovoltaikvorrichtung nach einem der Ansprüche 1 bis 7, die ferner einen planaren TCO-Kontakt (256) oberhalb der wenigstens einen Nanodrahtstruktur umfasst.

10. Photovoltaikvorrichtung nach Anspruch 1, wobei der Kern (120, 220) vom p-Typ einen Radius über 300 nm, bevorzugt 400 nm aufweist, und aus GaAs mit einer Dotierungsdichte über $10^{18}$ $cm^{-3}$, bevorzugt $10^{19}$ $cm^{-3}$ ausgebildet ist, die Hülle (130, 230) vom n-Typ eine Dicke von weniger als 50 nm, bevorzugt 40 nm aufweist, und aus $Al_{0,2}Ga_{0,8}As$ mit einer Dotierungsdichte von weniger als $10^{17}$ $cm^{-3}$, bevorzugt $10^{16}$ $cm^{-3}$ ausgebildet ist, und die Nanodrahtstruktur eine Länge von mehr als 5 $\mu$m, bevorzugt zwischen 5 $\mu$m und 7 $\mu$m und stärker bevorzugt 6 $\mu$m aufweist.

11. Solarzelle, die mehrere Photovoltaikvorrichtungen nach einem der Ansprüche 1 bis 10 umfasst, wobei die mehreren Photovoltaikvorrichtungen in einer Anordnung mit einem Packungsprozentsatz zwischen 50 und 55 % angeordnet sind.

12. Photovoltaikvorrichtung nach Anspruch 1, die ferner einen planaren TCO-Kontakt (256) oberhalb der wenigstens einen Nanodrahtstruktur umfasst, wobei das isolierende Polymer (255) jede der wenigstens einen Nanodrahtstruktur umgibt und die Lücken zwischen den Nanodrahtstrukturen ausfüllt.

13. Verfahren zum Herstellen einer Photovoltaikvorrichtung, das wenigstens einen Nanodraht umfasst, der auf einem Substrat (110, 210) gezüchtet wird, wobei das Verfahren Folgendes umfasst:
Züchten eines Nanodrahts, der einen stark dotierten Kern (120, 220) vom p-Typ, der ein proximales Ende, das an dem Substrat (110, 210) befestigt ist, und ein distales Ende aufweist, das sich von dem Substrat weg erstreckt, und eine Hülle (130, 230) vom n-Typ umfasst, die derart um den Kern (120, 220) vom p-Typ herum liegt, dass die hergestellte Photovoltaikvorrichtung eine Photovoltaikvorrichtung nach einem der Ansprüche 1 bis 10 ist.

**Revendications**

1. Dispositif photovoltaïque comprenant au moins une structure à nanofils fixée à un substrat (110, 210), dans lequelchacune des au moins une structure à nanofils comprend :

   un noyau de type p fortement dopé (120, 220) ayant une extrémité proximale fixée au substrat (110, 210) et une extrémité distale s'étendant à distance du substrat (110, 210) ; et
   une coque de type n légèrement dopée (130, 230) autour du noyau de type p (120, 220) de manière à former une jonction pn radiale ;
   le noyau de type p (120, 220) étant formé de GaAs et la coque de type n (130, 230) étant formée d'$Al_xGa_{1-x}As$, x ayant une valeur inférieure ou égale à 0,2 ;
   la densité de dopage de la coque de type n (130, 230) étant inférieure à $10^{17}$ cm$^{-3}$; et
   la densité de dopage du noyau de type p (120, 220) étant supérieure à $10^{18}$cm$^{-3}$.

2. Dispositif photovoltaïque selon la revendication 1, dans lequel la densité de dopage du noyau de type p (120, 220) est de $10^{19}$cm$^{-3}$.

3. Dispositif photovoltaïque selon l'une quelconque des revendications précédentes, dans lequel la densité de dopage de la coque de type n (130, 230) est de $10^{16}$cm$^{-3}$.

4. Dispositif photovoltaïque selon l'une quelconque des revendications précédentes, dans lequel la coque de type n (130, 230) a une épaisseur comprise entre 20 nm et 50 nm, et de préférence 30 nm ; et/ou
   le diamètre du noyau de type p (120, 220) étant supérieur à 300 nm, et de préférence 400 nm.

5. Dispositif photovoltaïque selon l'une quelconque des revendications précédentes, dans lequel la longueur du nanofil est comprise entre 5 $\mu$m et 7 $\mu$m, et de préférence 6 $\mu$m.

6. Dispositif photovoltaïque selon l'une quelconque des revendications précédentes, dans lequel le substrat (110, 210) comprend du silicium ; et/ou
   le substrat comprenant une couche graphitique.

7. Dispositif photovoltaïque selon l'une quelconque des revendications précédentes, dans lequel l'extrémité distale du nanofil comprend un revêtement antireflet.

8. Dispositif photovoltaïque selon l'une quelconque des revendications précédentes, dans lequel chacune des au moins une structure à nanofils est revêtue d'un oxyde conducteur transparent (OCT) (150, 250).

9. Dispositif photovoltaïque selon l'une quelconque des revendications 1 à 7, comprenant en outre un contact OCT planaire (256) au-dessus de l'au moins une structure à nanofils.

10. Dispositif photovoltaïque selon la revendication 1, dans lequel le noyau de type p (120, 220) a un rayon supérieur à 300 nm, de préférence 400 nm, et est formé de GaAs avec une densité de dopage supérieure à $10^{18}$ cm$^{-3}$, de préférence $10^{19}$ cm$^{-3}$, la coque de type n (130, 230) a une épaisseur inférieure à 50 nm, de préférence 40 nm, et est formée d'$Al_{0,2}Ga_{0,8}As$ avec une densité de dopage inférieure à $10^{17}$ cm$^{-3}$, de préférence $10^{16}$cm$^{-3}$, et la structure à nanofils a une longueur supérieure à 5 $\mu$m, de préférence entre 5 $\mu$m et 7 $\mu$m, et plus préférablement 6 $\mu$m.

11. Cellule solaire comprenant une pluralité de dispositifs photovoltaïques selon l'une quelconque des revendications 1 à 10, dans laquelle la pluralité de dispositifs photovoltaïques est agencée en un réseau avec un pourcentage de tassement compris entre 50 et 55 %.

12. Dispositif photovoltaïque selon la revendication 1, comprenant en outre un contact OCT planaire (256) au-dessus des au moins une structure à nanofils, dans lequel un polymère isolant (255) entoure chacune des au moins une structure à nanofils et remplit les espaces entre les structures à nanofils.

13. Procédé de fabrication d'un dispositif photovoltaïque comprenant au moins un nanofil cultivé sur un substrat (110, 210), le procédé comprenant :
    la culture d'un nanofil comprenant un noyau de type p fortement dopé (120, 220) ayant une extrémité proximale fixée au substrat (110, 210) et une extrémité distale s'étendant à distance du substrat, et une coque de type n (130, 230) autour du noyau de type p (120, 220), de telle sorte que le dispositif photovoltaïque fabriqué est un dispositif photovoltaïque selon l'une quelconque des revendications 1 à 10.

FIG. 1

FIG. 2A

*FIG. 2B*

FIG. 3

FIG. 4

FIG. 4 Cont'd

FIG. 4 Cont'd

FIG. 5

FIG. 6

FIG. 7

FIG. 7 Cont'd

*FIG. 8*

FIG. 9

FIG. 10

FIG. 11

EP 3 033 773 B1

*FIG. 12*

EP 3 033 773 B1

FIG. 13

FIG. 14

FIG. 15

*FIG. 16*

FIG. 17

**FIG. 18**

**FIG. 19**

FIG. 20

FIG. 21

*FIG. 22*

FIG. 23

FIG. 23 Cont'd

EP 3 033 773 B1

FIG. 23 Cont'd

FIG. 24

FIG. 25

FIG. 26

**EP 3 033 773 B1**

**REFERENCES CITED IN THE DESCRIPTION**

**Patent documents cited in the description**

- US 2010193768 A1
- US 2011126891 A1
- US 2012032148 A1
- FR 2932013 A1